# EUROPEAN PATENT APPLICATION

(11) **EP 2 485 268 A1**
(43) Date of publication of application: **08.08.2012**
(21) Application number: 09850054.9
(22) Date of filing: 30.09.2009
(51) Int. Cl.: H01L 31/042

(54) **SOLAR CELL PANEL**

(71) Applicant: Mitsubishi Heavy Industries, Ltd., Tokyo 108-8215 (JP)
(72) Inventor: KITAMURA, Takashi, Tokyo 108-8215 (JP); HORIOKA, Tatsuji, Tokyo 108-8215 (JP); MAEDA, Katsuhiko, Tokyo 108-8215 (JP); OOKA, Junji, Tokyo 108-8215 (JP); MAMASE, Shinichiro, Tokyo 108-8215 (JP)
(74) Representative: Bongiovanni, Simone
(86) International application number: PCT/JP2009/067062
(87) International publication number: WO 2011/039863

(57) **Abstract**

A solar cell panel that is capable of preventing damage to the edge portions of the panel. The solar cell panel is provided with a pair of first protective ribs (103L, 103L), which are fixed to the back substrate, protrude outward from the edges of a solar cell module (2) and are disposed in an opposing manner, a pair of support ribs (3S, 3S), which are fixed to the back substrate and are disposed across the space between the pair of first protective ribs (103L, 103L) at positions distant from the edges of the back substrate, and a pair of second protective ribs (104P, 104P), which are disposed across the space between the pair of first protective ribs (103L, 103L) and protrude outward from the edges of the solar cell module (2).

## Description

### Technical Field

The present invention relates to a solar cell panel, and relates particularly to a thin-film solar cell panel in which the electric power generation layer is formed by deposition.

### Background Art

Conventional solar cell panels are produced by forming a thin-film silicon-based solar cell on a glass substrate having a thickness of approximately 4 mm and dimensions of approximately 1.4 m × approximately 1.1 m, sealing the structure using a sealing agent (EVA) and a backing sheet (having a PET/Al/PET structure), and then attaching the sealed structure to an aluminum frame.
The material cost of the above-mentioned aluminum frame represents approximately 10% to approximately 20% of the total materials cost of the solar cell panel, meaning the aluminum frame is one of the most expensive materials used in the production of the solar cell panel.

Accordingly, it is thought that abbreviating or simplifying the aluminum frame should be effective in reducing the production cost of a solar cell panel having the type of structure outlined above.
Specifically, by replacing the backing sheet disposed on the back surface of the solar cell panel with a glass substrate, and allowing the glass substrate to bear at least some of the strength load borne by the aluminum frame, the aluminum frame can be abbreviated or simplified (for example, see PTL 1).
This type of structure in which glass substrates are positioned on both the upper surface and the back surface of the solar cell panel is referred to as a double glass structure in the following description.

On the other hand, in the case of solar cell panels having a backing sheet or the like on the back surface, the solar cell module is sometimes secured to the aluminum frame by inserting the edges of the solar cell module in a U-shaped edge within the aluminum frame.

However, if this type of solar cell panel is installed on an inclined surface, or installed vertically as a building material on a building or the like, then a problem arises in that the electric power generation surface area of the solar cell panel is reduced.
In other words, a level difference is formed at the securing portions between the sunlight-incident side of the solar cell module surface and the aluminum frame, and when the solar cell panel is installed on an inclined surface, moisture and dust tends to accumulate at the level difference on the low side of the incline. This moisture or dust blocks incident light from entering the solar cell panel, resulting in an associated reduction in the electric power generation surface area.

Positioning a solar cell module in a perpendicular arrangement relative to the angle of the incident sunlight yields better electric power generation efficiency than the case where the module is installed on a tilt, and therefore it is often recommended that the solar cell module is installed with an inclination of approximately 20° to 40° relative to the installation surface. However, this accentuates the above-mentioned reduction in electric power generation efficiency caused by installation of the solar cell module on an incline.

In the case of solar cell panels having the double glass structure described above, because the aluminum frame that supports the solar cell module is abbreviated or simplified, no portion of the aluminum frame is positioned on the surface of the solar cell module where incident light enters the module. As a result, the type of problem described above wherein moisture or dust accumulates on the surface where incident light enters does not arise, meaning there is no reduction in the electric power generation surface area.

### Citation List

### Patent Literature

{PTL 1} Japanese Unexamined Patent Application, Publication No. Sho 61-199674

### Summary of Invention

### Technical Problem

In a solar cell module having a double glass structure, penetration of external moisture and the like into the module is generally inhibited by forming the solar cell electric power generation layer on a transparent glass substrate, and then bonding a back glass substrate to the structure via a sealing material (EVA) in a lamination step, thereby sealing the module.
In this description, the structure produced following completion of this lamination step is termed a "solar cell module", whereas the product produced following completion of all of the production steps is termed a "solar cell panel".

In those cases where a solar cell panel having a double glass structure is installed on an outside attachment mount or the like, because the panel lacks the aluminum frame of a conventional solar cell panel, the periphery of the double glass structure solar cell panel is usually clamped within attachment brackets, with these attachment brackets then fitted to the mount or the like. Accordingly, the edge portions of the solar cell module are generally exposed.

However, if the edge portions of the solar cell module, namely the edge portions of the transparent substrate and the back substrate, are exposed, then when these edge portions of the solar cell panel are exposed to even a comparatively light impact, for example if the edge portions are bumped during production or installation of the solar cell panel, the edge portions of the transparent substrate and the back substrate are easily damaged. If the edge portions are damaged in this manner, then various problems may arise, including a deterioration in the power generation characteristics of the solar cell module, or a deterioration in the solar cell module performance caused by penetration of moisture into the module.
Particularly in the case of large solar cell panels having a surface area exceeding 1 m², because the mass of each panel can exceed 20 kg and handling is difficult, damage to the edge portions of the panel caused by inadvertent bumping of the edge portions during production or installation becomes more likely, and an effective solution to this problem is keenly sought.

The present invention has been developed to address the issues described above, and has an object of providing a solar cell panel that is capable of preventing damage to the edge portions of the panel.

### Solution to Problem

In order to achieve the above object, the present invention provides the aspects described below.
The present invention provides a solar cell panel comprising: a solar cell module in which a transparent substrate, a photovoltaic layer formed on the transparent substrate, and a back substrate that seals the photovoltaic layer between the transparent substrate and the back substrate are stacked, in that order, with the transparent substrate disposed closest to the surface through which incident light enters; a pair of first protective ribs, which are fixed to the back substrate, protrude outward from the edges of the solar cell module, and are disposed in an opposing manner; a pair of support ribs, which are fixed to the back substrate and are disposed across the space between the pair of first protective ribs at positions distant from the edges of the back substrate; and a pair of second protective ribs, which are disposed across the space between the pair of first protective ribs, and protrude outward from the edges of the solar cell module.

According to the present invention, because the pair of first protective ribs and the pair of second protective ribs protrude outward from the edges of the solar cell module, if an edge of the solar cell module is bumped, then one of the first protective ribs or second protective ribs will make contact before the edge of the transparent substrate or the back substrate. Accordingly, damage to the edge portions of the solar cell panel can be prevented.

In one aspect of the invention described above, at least one of the first protective ribs and the second protective ribs preferably has a structure comprising a contact portion, which contacts and is fixed to the back substrate, and protrudes outward from the edge of the solar cell module in a plate-like form; and a protective wall which extends toward the solar cell module from a portion of the contact portion disposed beyond the outside edge of the solar cell module.

By employing this type of structure, if an edge of the solar cell panel is bumped, then the contact portion or protective wall make contact before the edge of the transparent substrate or the back substrate. Because the protective wall extends toward the solar cell module from the contact portion, thereby covering the edges of the solar cell module (namely, the edges of the transparent substrate and the back substrate), the edges of the solar cell module can be protected more reliably than the case where only the contact portion is provided. Accordingly, the effect of the invention in preventing damage to the edge portions of the solar cell panel can be enhanced.

In another aspect of the invention described above, at least one of the first protective ribs and the second protective ribs preferably has a structure comprising a contact portion, which contacts and is fixed to the back substrate, and protrudes outward from the edge of the solar cell module in a plate-like form; and a protective wall which extends away from the solar cell module from a portion of the contact portion disposed beyond the outside edge of the solar cell module.

By employing this type of structure, if an edge of the solar cell panel is bumped, then the contact portion or protective wall make contact before the edge of the transparent substrate or the back substrate. Accordingly, the edges of the solar cell module can be protected more reliably, and the effect of the invention in preventing damage to the edge portions of the solar cell panel can be enhanced.

In the structures described above, a sealing material is preferably disposed between the edges of the solar cell module and at least one of the protective wall and the contact portion.

By using a sealing material in this manner, the waterproofing performance at the peripheral edges of the solar cell module can be improved, enabling the reliability of the solar cell module to be improved. Moreover, compared with the case where no sealing material is used, the adhesive strength can be enhanced between at least one of the first protective ribs and the second protective ribs, and the transparent substrate and the back substrate.
Further, because the sealing material exhibits elasticity, the cushioning effect between at least one of the first protective ribs and the second protective ribs, and the transparent substrate and the back substrate, can be enhanced compared with the case where no sealing material is used, enabling better prevention of damage to the edge portions of the solar cell panel.

In another aspect of the invention described above, at least one of the first protective ribs and the second protective ribs preferably has a structure provided with a contact portion that contacts and is fixed to the back substrate, wherein the contact portion protrudes outward from the edge of the solar cell module in a plate-like form.

By employing this type of structure, if an edge of the solar cell panel is bumped, then the contact portion makes contact before the edge of the transparent substrate or the back substrate. Accordingly, a simple rib-shaped structure can be used to prevent damage to the edge portions of the solar cell panel.

In the structure described above, a sealing material is preferably disposed between the edges of the solar cell module and the contact portion.

By using a sealing material in this manner, the waterproofing performance at the peripheral edges of the solar cell module can be improved, enabling the reliability of the solar cell module to be improved. Moreover, compared with the case where no sealing material is used, the adhesive strength can be enhanced between at least one of the first protective ribs and the second protective ribs, and the transparent substrate and the back substrate.
Further, because the sealing material exhibits elasticity, the cushioning effect between at least one of the first protective ribs and the second protective ribs, and the transparent substrate and the back substrate, can be enhanced compared with the case where no sealing material is used, enabling better prevention of damage to the edge portions of the solar cell panel.

In another aspect of the invention described above, the edge regions of a contact surface between the back substrate and the contact portion of at least one of the support ribs, the first protective ribs and the second protective ribs are affixed with a double-sided tape having a pressure-sensitive adhesive coated on both surfaces, and a region of the contact surface sandwiched between sections of the double-sided tape is affixed with an adhesive.

According to this aspect of the present invention, the two members being bonded can be positioned relative to each other more easily than the case where the support ribs, the first protective ribs and/or the second protective ribs are bonded to the back substrate using only an adhesive, and the two members need not be secured until the adhesive curing period has elapsed, meaning the bonding process is simplified.
Moreover, the thickness of the double-sided tape maintains a space between the two members for the adhesive layer, ensuring an adhesive layer thickness that is capable of providing good adhesive performance. By positioning the double-sided tape along the edge regions of the contact surface, and then disposing the adhesive between the sections of the tape, leakage of the adhesive outside the contact surface is prevented.

Compared with the case where the support ribs, the first protective ribs and/or the second protective ribs are bonded to the back substrate using only a double-sided tape, the amount of double-sided tape used can be reduced, the production costs can be reduced, and the durability of the resulting structure can be improved.

In another aspect of the invention described above, the contact surface between the back substrate and the contact portion of at least one of the support ribs, the first protective ribs and the second protective ribs is preferably provided with a spacer that determines the spacing between the back substrate and at least one of the support ribs, the first protective ribs and the second protective ribs, and an adhesive that affixes the back substrate to at least one of the support ribs, the first protective ribs and the second protective ribs.

According to this aspect of the present invention, by using the spacer to regulate the spacing between the back substrate and the support ribs, the first protective ribs and/or the second protective ribs, the layer of the adhesive between the two members can be maintained at an appropriate thickness, thereby ensuring an adhesive layer thickness that is capable of providing good adhesive performance.

In another aspect of the invention described above, a fixture is preferably provided for affixing the first protective ribs to an installation surface for the solar cell module, and the first protective ribs preferably comprise a contact portion, which contacts and is fixed to the back substrate, and protrudes outward from the edge of the solar cell module in a plate-like form, and an engagement portion, which is disposed on a portion of the contact portion beyond the outside edge of the solar cell module, extends toward the solar cell module, and engages with the fixture.

According to this aspect of the present invention, the first protective ribs can be affixed to the installation surface by engaging the fixture and the engagement portion, and then securing a fixing portion to the installation surface with the fixture and the engagement portion in an engaged state, thereby fixing the solar cell panel to the installation surface.

Moreover, unlike the case where the engagement portion is disposed on the first protective ribs in the vicinity of the installation surface, the engagement portion is provided on the contact portion that is affixed to the back substrate, and therefore the operation of affixing the solar cell panel to the installation surface is simplified, and the edges of the solar cell module are less prone to damage.

In other words, in the case where the engagement portion is disposed in the vicinity of the installation surface, the tool for securing the fixture must travel past the side of the solar cell module to a position close to the installation surface, meaning there is a possibility that the tool may make contact with a edge portion of the solar cell module, resulting in damage to the edge of the solar cell module. In contrast, in the case where the engagement portion is disposed on the contact portion, the above-mentioned tool need not travel past the side of the solar cell module, meaning workability is more favorable. Accordingly, the edges of the solar cell module are less prone to damage during affixing of the solar cell panel to the installation surface.

### Advantageous Effects of Invention

According to the solar cell panel of the present invention, a pair of first protective ribs and a pair of second protective ribs protrude outward from the edges of the solar cell module, and therefore if an edge of the solar cell module is bumped, the first protective ribs or the second protective ribs make contact before the edge of the transparent substrate or the back substrate, meaning damage to the edge portions of the solar cell panel can be prevented.

### Brief Description of Drawings

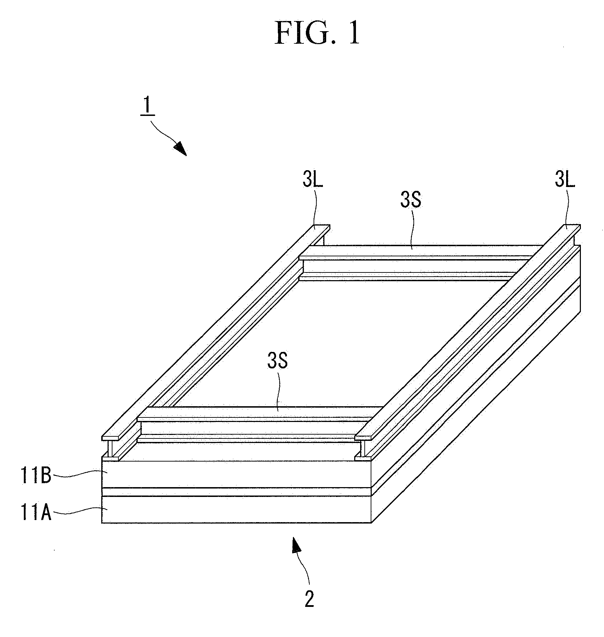

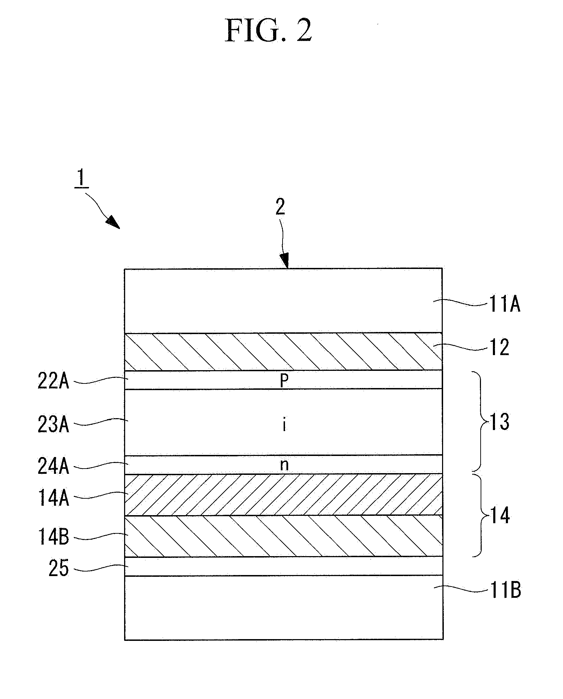

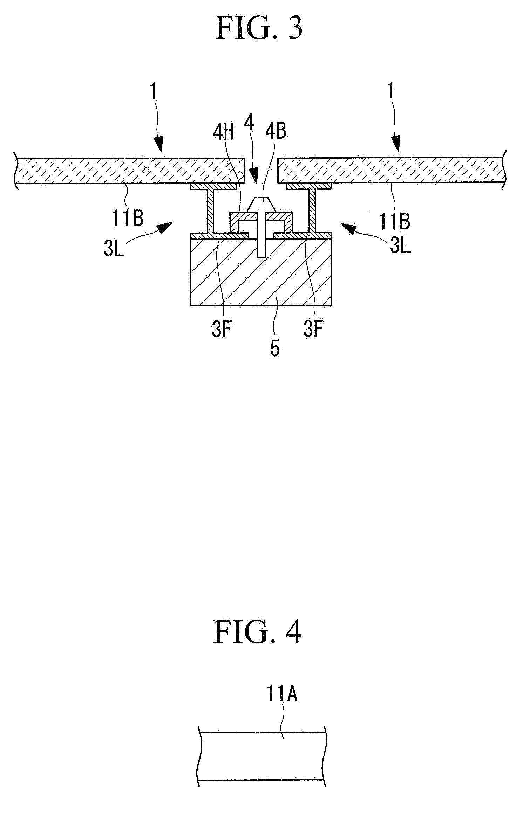

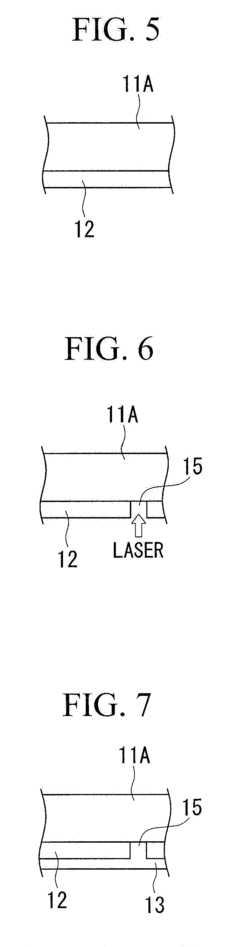

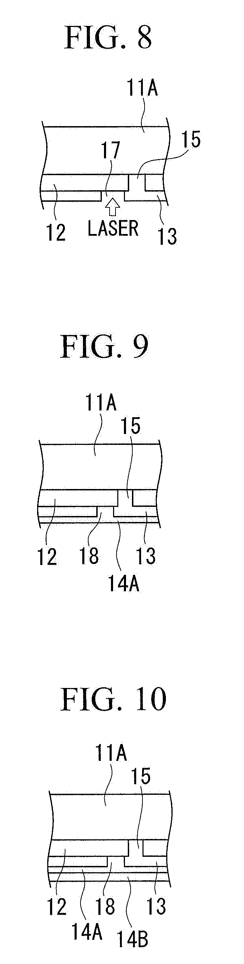

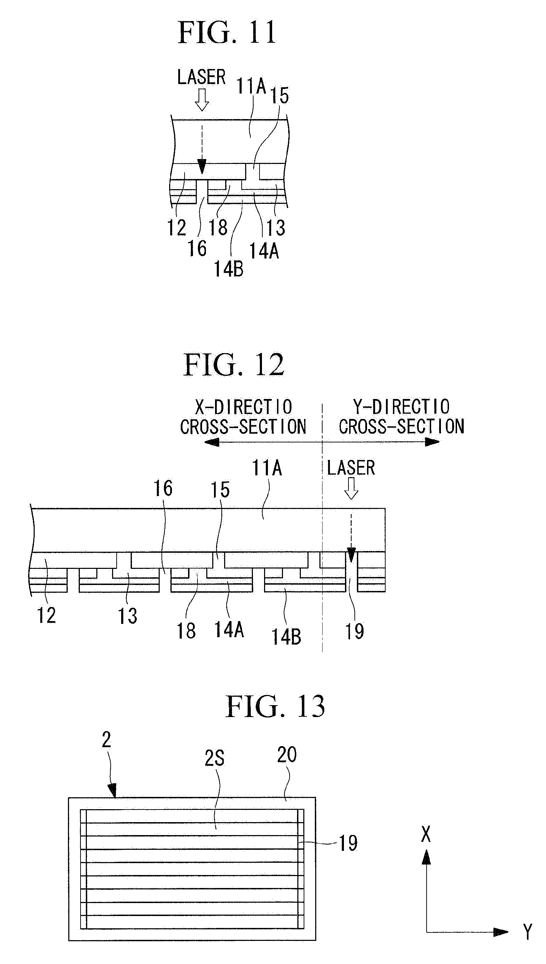

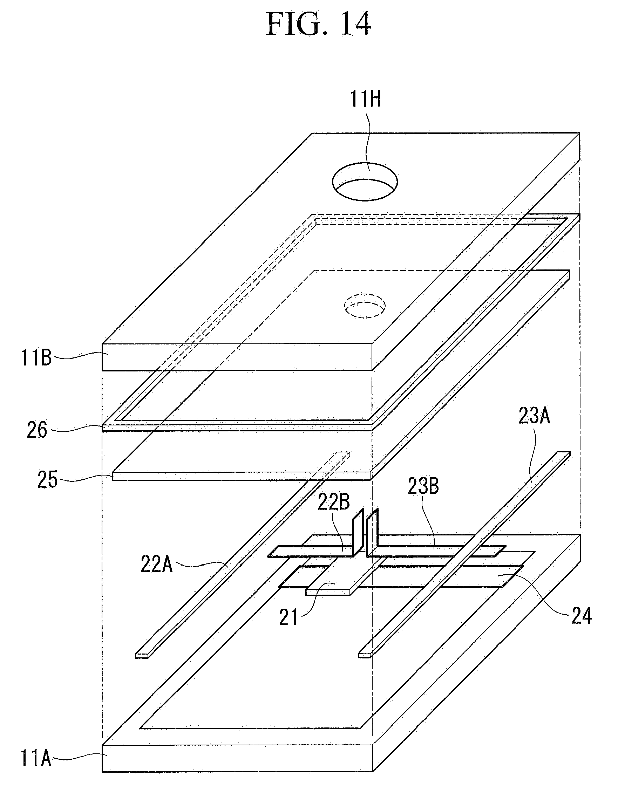

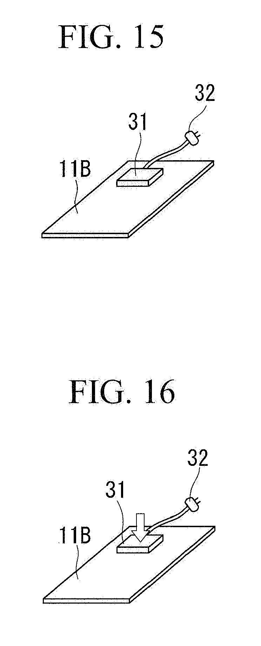

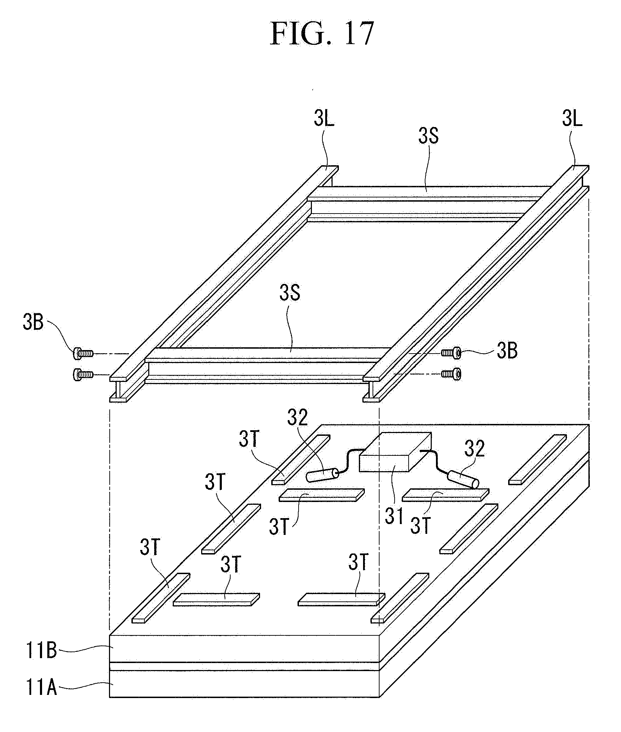

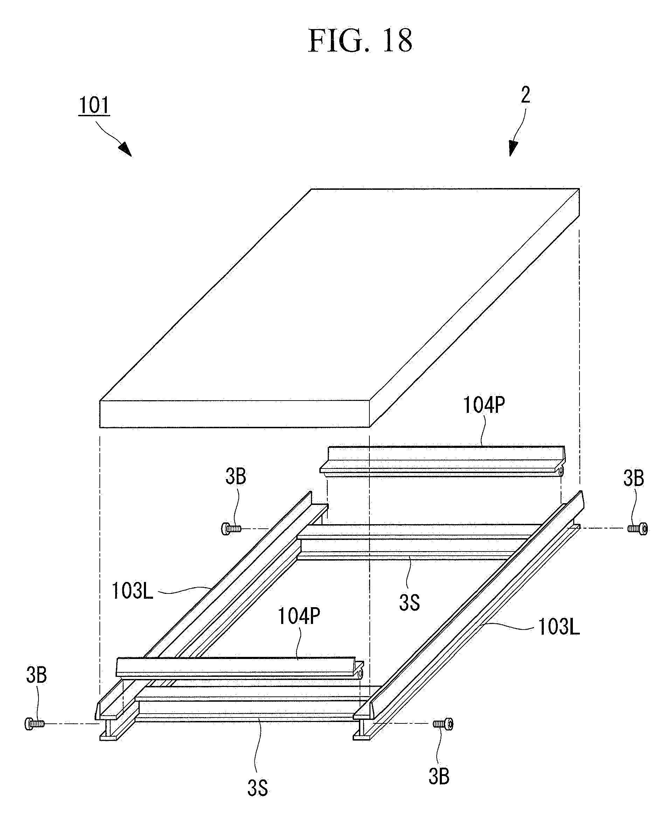

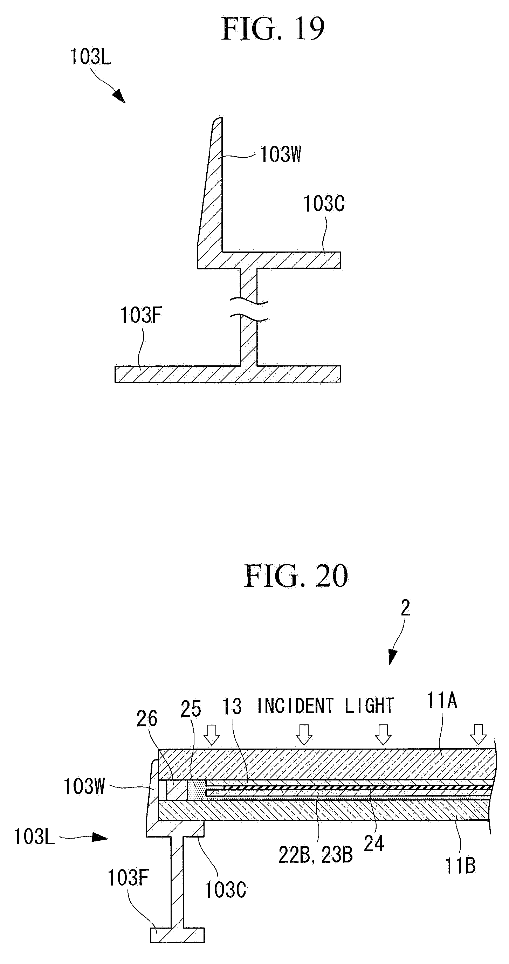

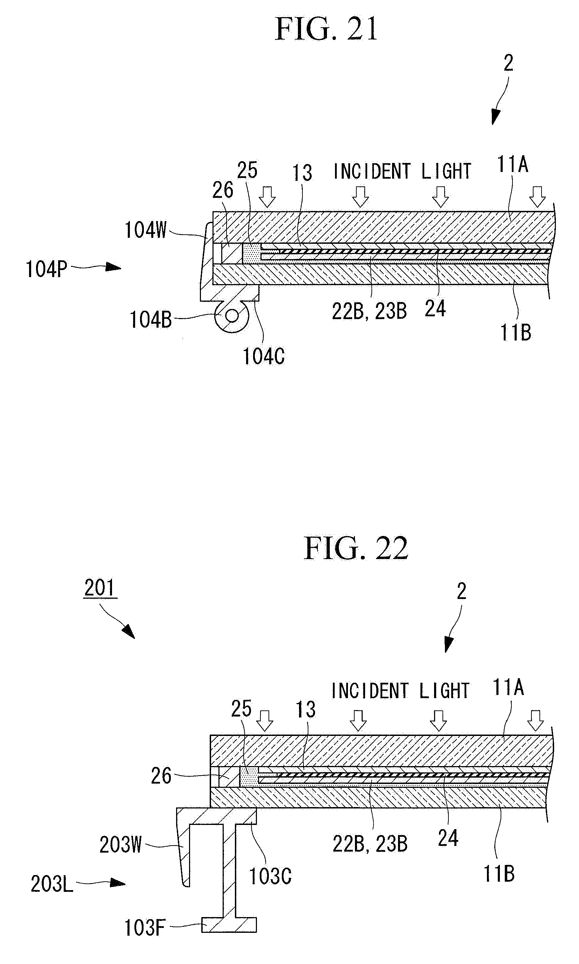

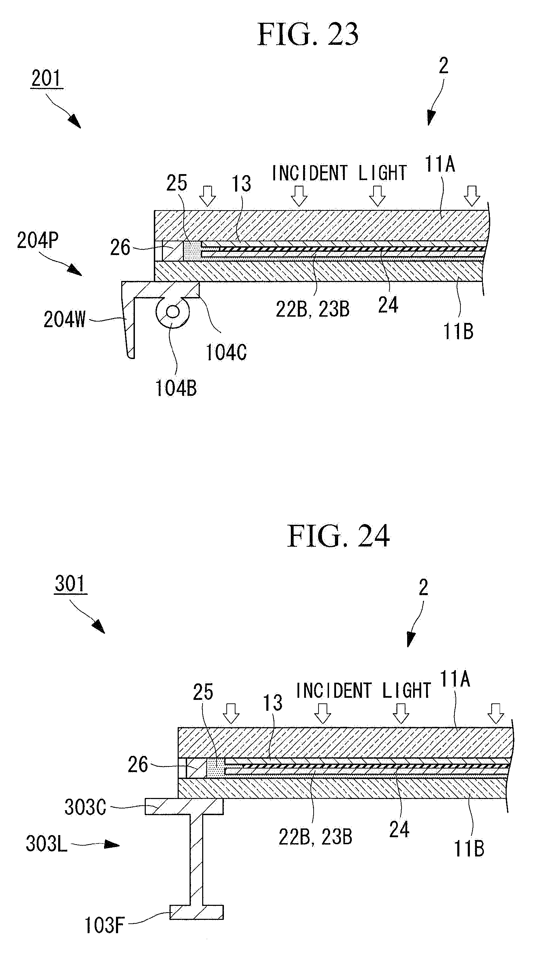

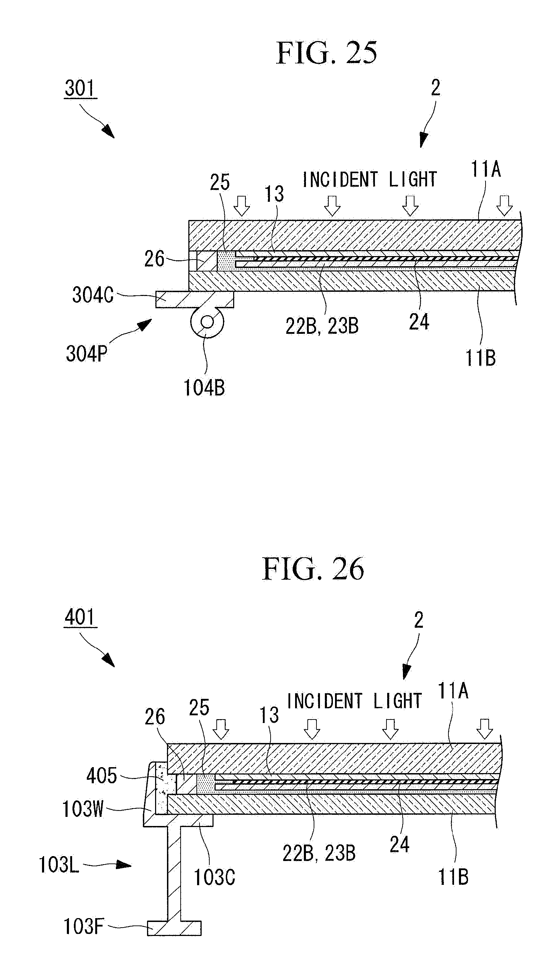

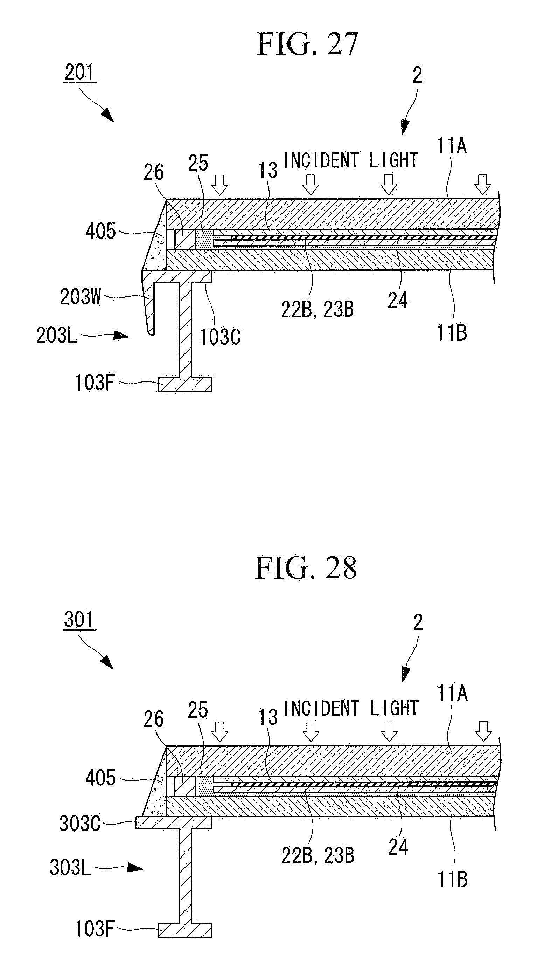

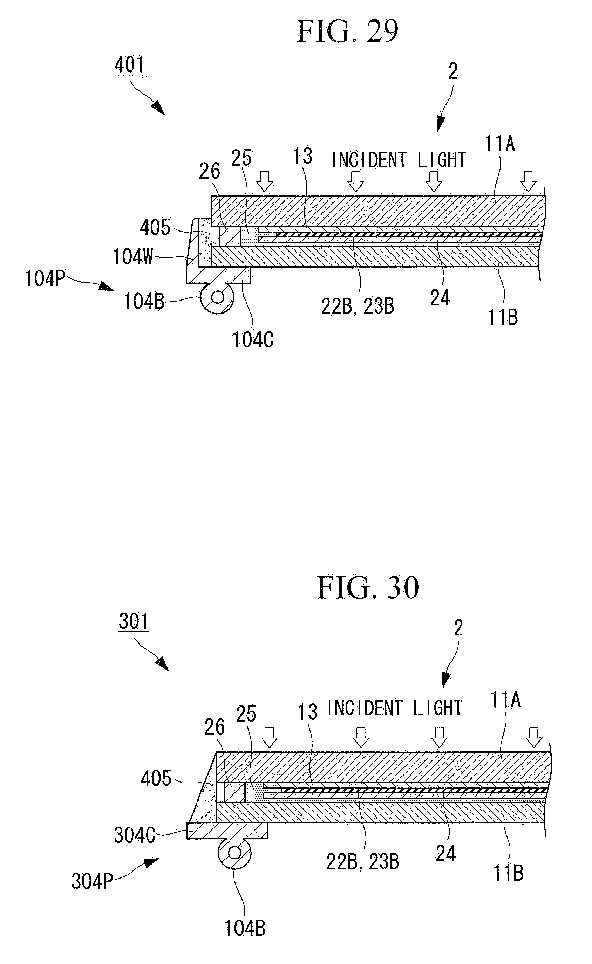

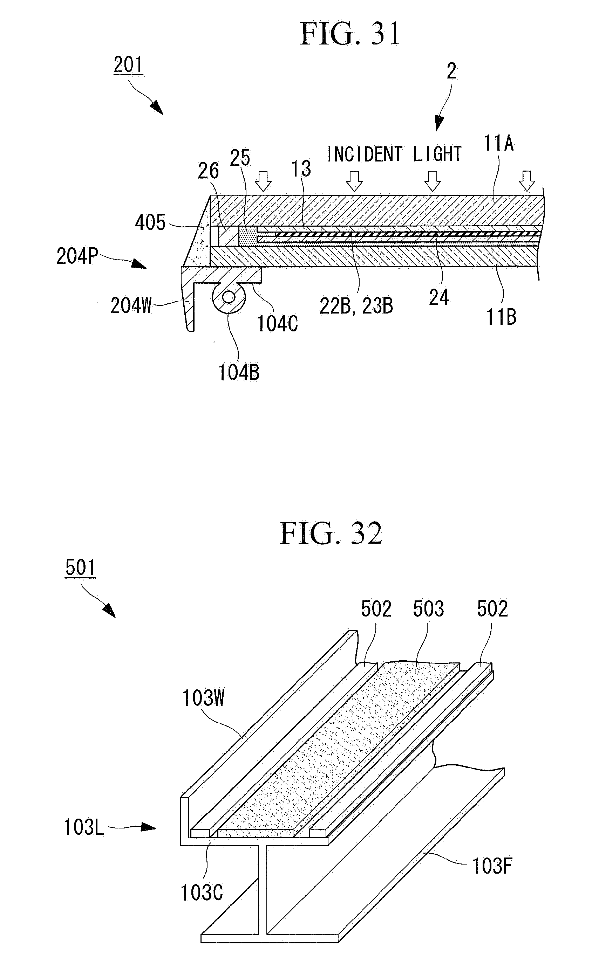

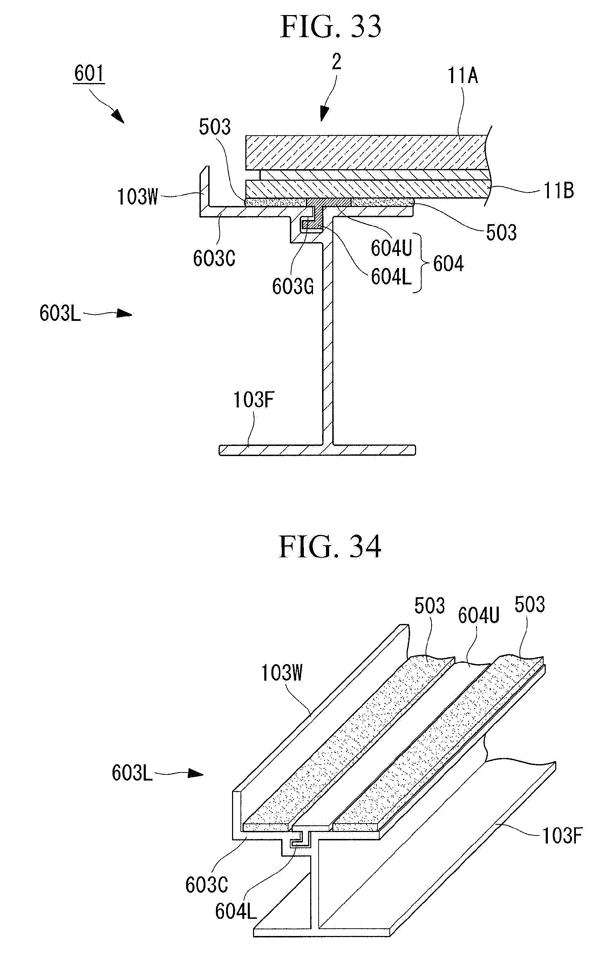

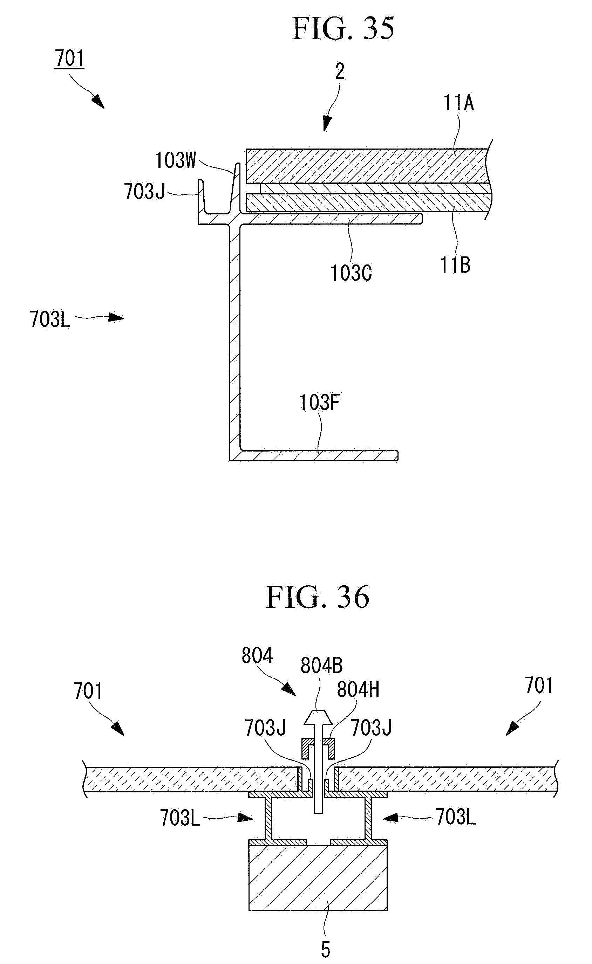

{Fig. 1} A schematic illustration describing the structure of a solar cell panel according to a reference embodiment of the present invention.
{Fig. 2} A schematic illustration describing the structure of the solar cell module of Fig. 1.
{Fig. 3} A schematic illustration describing the state where the solar cell panel of Fig. 1 is affixed to an installation surface.
{Fig. 4} A schematic illustration describing a production process for the solar cell module of Fig. 2.
{Fig. 5} A schematic illustration describing a step of forming a transparent electrode layer in the production process for the solar cell module of Fig. 2.
{Fig. 6} A schematic illustration describing a step of forming a transparent electrode layer slot in the production process for the solar cell module of Fig. 2.
{Fig. 7} A schematic illustration describing a step of stacking a photovoltaic layer in the production process for the solar cell module of Fig. 2.
{Fig. 8} A schematic illustration describing a step of forming a connection groove in the production process for the solar cell module of Fig. 2.
{Fig. 9} A schematic illustration describing a step of stacking a back electrode layer in the production process for the solar cell module of Fig. 2.
{Fig. 10} A schematic illustration describing a step of stacking a back electrode layer in the production process for the solar cell module of Fig. 2.
{Fig. 11} A schematic illustration describing a step of producing an isolation groove in the production process for the solar cell module of Fig. 2.
{Fig. 12} A schematic illustration describing a step of producing an insulation slot in the production process for the solar cell module of Fig. 2.
{Fig. 13} An illustration of the solar cell module viewed from the back electrode layer side, describing the formation of the insulation slot of Fig. 12.
{Fig. 14} A schematic illustration describing the stacking of a back substrate and the like on the transparent substrate of Fig. 13.
{Fig. 15} A schematic illustration describing a step of attaching a terminal box in the production process for the solar cell module of Fig. 2.
{Fig. 16} A schematic illustration describing a sealing step in the production process for the solar cell module of Fig. 2.
{Fig. 17} A schematic illustration describing a step of attaching long-side ribs and short-side ribs to the solar cell module.
{Fig. 18} A schematic illustration describing the structures of long-side ribs, short-side ribs and protective ribs for a solar cell panel according to a first embodiment of the present invention.
{Fig. 19} A cross-sectional view describing the structure of a long-side rib from Fig. 18.
{Fig. 20} A schematic illustration describing a state in which the solar cell module is supported on a long-side rib from Fig. 18.
{Fig. 21} A schematic illustration describing a state in which the solar cell module is supported on a protective rib from Fig. 18.
{Fig. 22} A cross-sectional view describing the structure of a long-side rib of a solar cell panel according to a first modified example of the first embodiment of the present invention.
{Fig. 23} A cross-sectional view describing the structure of a protective rib of a solar cell panel according to a first modified example of the first embodiment of the present invention.
{Fig. 24} A cross-sectional view describing the structure of a long-side rib of a solar cell panel according to a second modified example of the first embodiment of the present invention.
{Fig. 25} A cross-sectional view describing the structure of a protective rib of a solar cell panel according to a second modified example of the first embodiment of the present invention.
{Fig. 26} A cross-sectional view describing the structure of a long-side rib of a solar cell panel according to a second embodiment of the present invention.
{Fig. 27} A cross-sectional view describing the structure of a long-side rib of a solar cell panel according to a modified example of the second embodiment of the present invention.
{Fig. 28} A cross-sectional view describing another structure of a long-side rib of a solar cell panel according to a modified example of the second embodiment of the present invention.
{Fig. 29} A cross-sectional view describing the structure of a protective rib of a solar cell panel according to the second embodiment of the present invention.
{Fig. 30} A cross-sectional view describing another structure of a protective rib of a solar cell panel according to a modified example of the second embodiment of the present invention.
{Fig. 31} A cross-sectional view describing yet another structure of a protective rib of a solar cell panel according to a modified example of the second embodiment of the present invention.
{Fig. 32} A schematic illustration describing a method of bonding a solar cell panel to a long-side rib for a solar cell panel according to a third embodiment of the present invention.
{Fig. 33} A schematic illustration describing a method of bonding a solar cell panel to a long-side rib for a solar cell panel according to a fourth embodiment of the present invention.
{Fig. 34} A perspective view describing the structures of the long-side rib and the spacer from Fig. 33.
{Fig. 35} A schematic illustration describing the structure of a long-side rib in a solar cell panel according to a fifth embodiment of the present invention.
{Fig. 36} A schematic illustration describing a method of installing the solar cell panel of Fig. 35.

### Description of Embodiments

A solar cell panel according to a reference embodiment of the present invention is described below with reference to Fig. 1 to Fig. 17.
Fig. 1 is a schematic illustration describing the structure of a solar cell panel according to this embodiment.
The solar cell panel 1 described in this embodiment is a silicon-based solar cell panel comprising a solar cell module 2, and as illustrated in Fig. 1, the solar cell panel 1 is provided with a pair of long-side ribs 3L, 3L, and a pair of short-side ribs 3S, 3S.

Fig. 2 is a schematic illustration describing the structure of the solar cell module of Fig. 1.
As illustrated in Fig. 2, the solar cell module 2 comprises mainly a transparent substrate 11A, a transparent electrode layer 12, a photovoltaic layer 13, a back electrode layer 14, an encapsulant sheet 25, and a back substrate 11B.

The transparent substrate 11A is a glass substrate, and typically employs a soda float glass or figured glass or the like. Further, glass types known as soda-lime glass and white crown glass are commonly used as the glass material, and either of these glass types can be used as the substrate.

In terms of the transmission properties relative to light of 350 nm to 800 nm, which represents the light absorption wavelength of the photovoltaic layer 13, a white crown glass having a low iron content and a high degree of transmittance is preferable to a soda-lime glass for the transparent substrate 11A. Further, in order to ensure sufficient strength for a solar cell module 2 having a surface area exceeding 1 m², the thickness of the glass substrate is preferably within a range from approximately 2.8 mm to approximately 4.5 mm, and is more preferably within a range from approximately 3.0 mm to approximately 3.2 mm.

When white crown glass is used as the transparent substrate 11A, the transmittance at a wavelength of 500 nm is at least 91%, and the transmittance at 1,000 nm is at least 89%. In contrast, when a soda-lime glass is used, the transmittance at a wavelength of 500 nm is approximately 89%, and the transmittance at 1,000 nm is between approximately 75% and 80%, representing a slightly lower transmittance than white crown glass for these wavelengths.

Because it is not required to transmit light, the back substrate 11B is preferably a glass substrate formed from soda-lime glass, which is significantly less expensive than white crown glass. Further, the back substrate 11B is preferably thinner than the transparent substrate 11A, with a thickness within a range from approximately 1.8 mm to approximately 3.2 mm, and more preferably within a range from approximately 2.0 mm to approximately 2.2 mm. Ensuring that the thickness of the back substrate 11B is less than that of the transparent substrate 11A, thereby lightening the back substrate 11B relative to the transparent substrate 11A, makes the production process for the solar cell module 2 somewhat easier.

The present embodiment is described in relation to the case where both the transparent substrate 11A and the back substrate 11B have a surface area exceeding 1 m² (for example, dimensions of 1.4 m × 1.1 m). Both substrates may or may not be subjected to corner chamfering or the like, and there are no particular limitations in this regard.

As illustrated in Fig. 1, the pair of long-side ribs 3L, 3L and the pair of short-side ribs 3S, 3S are fixed to the back substrate 11B of the solar cell module 2 and support the solar cell module 2. Moreover, the pair of long-side ribs 3L, 3L and the pair of short-side ribs 3S, 3S are formed from a metal material such as aluminum or an aluminum alloy, and therefore reinforce the strength of the back substrate 11B.
The present embodiment describes an example in which one pair of each of the long-side ribs 3L and the short-side ribs 3S are provided, but the number of long-side ribs 3L and short-side ribs 3S installed to ensure the required level of strength for the solar cell panel 1 is not limited to a pair.

Moreover, the present embodiment is described in relation to the case where both the long-side ribs 3L and the short-side ribs 3S are formed with an I-shaped cross-section, but there are no particular limitations on the cross-sectional shape, and ribs having a U-shape cross-section may also be used to provide the required level of strength for the solar cell panel 1.

Fig. 3 is a schematic illustration describing a state where the solar cell panel of Fig. 1 is affixed to an installation surface.
The long-side ribs 3L are a pair of ribs that are disposed so as to extend along the long-side edges of the back substrate 11B of the solar cell panel 1. Moreover, as illustrated in Fig. 3, the long-side ribs 3L are used, together with a fixture 4, for affixing the solar cell panel 1 to a mounting structure 5 (installation surface) of a mount.

The fixture 4 sandwiches a flange 3F of the long-side ribs 3L against the mounting structure 5, thereby securing the long-side ribs 3L to the mounting structure 5. The fixture 4 comprises a fixing bolt 4B that is affixed to the mounting structure 5, and a holding portion 4H that sandwiches the flanges 3F of the long-side ribs 3L against the mounting structure 5.

In the present embodiment, the fixtures 4 are provided at four locations on each solar cell panel 1, and are preferably positioned at those locations on the long-side ribs 3L that correspond with extensions of the centerlines of the short-side ribs 3S, although the fixtures 4 may also be positioned at locations close to the extensions of the centerlines of the short-side ribs 3S, provided there are no adverse effects on the strength of the solar cell panel 1. Specifically, the regions within ±10 mm of the extensions of the centerlines of the short-side ribs 3S are preferred. The present embodiment describes the case where, in order to avoid interference between the short-side ribs 3S and the fixtures 4, the centerlines of the short-side ribs 3S are disposed on the inside of the fixtures 4, at positions approximately 10 mm from the edge of the holding portion 4H of each fixture 4.

By adopting this type of structure, when a load is placed on the solar cell panel 1, the central region of the stress within the long-side ribs 3L coincides with the fixing regions of the fixtures 4, meaning shear stress can be prevented from acting upon the long-side ribs 3L. Moreover, the load borne by the solar cell module 2 and the back substrate 11B can be reduced.

The short-side ribs 3S are a pair of ribs disposed across the space between the pair of long-side ribs 3L, and extend in a direction substantially parallel to the short-side edge of the back substrate 11B. The short-side ribs 3S are disposed at positions some distance toward the center from the short-side edges of the back substrate 11B.
In other words, the pair of long-side ribs 3L, 3L and the pair of short-side ribs 3S, 3S form a rectangular-shaped frame structure. The long-side ribs 3L and the short-side ribs 3S are fixed together using fastening members such as rib bolts 3B.

Relative to the total length of the long sides of the solar cell module 2 (for example, the back substrate 11B), the short-side ribs 3S are preferably disposed at positions that are offset toward the center from the short-side edges of the solar cell module 2 by a distance equivalent to approximately 12% to approximately 18% of the total length.
In the case of the present embodiment (namely, the case where the lengths of the long sides and the short sides of the back substrate 11B are 1.4 m × 1.1 m respectively), the short-side ribs 3S are disposed at positions that are offset by approximately 175 mm to approximately 250 mm toward the center from the short-side edges of the solar cell module 2.

Next is a description of a process for producing the solar cell panel 1 having the structure described above.
The present embodiment describes the example of a solar cell panel 1 in which a single-layer amorphous silicon thin film is deposited as the photovoltaic layer 13 on a glass substrate that functions as the transparent substrate 11A.

The photovoltaic layer 13 in the present embodiment is not limited to examples that employ a single-layer amorphous silicon solar cell. For example, the photovoltaic layer 13 may also be used within other varieties of thin-film solar cells such as crystalline silicon solar cells that employ microcrystalline silicon or the like, silicon-germanium solar cells, and multi-junction (tandem) solar cells in which one layer, or a plurality of layers, of each of an amorphous silicon solar cell and a crystalline silicon solar cell or silicon-germanium solar cell are stacked together.
Moreover, an intermediate contact layer that functions as a semi-reflective film for improving the contact properties and achieving electrical current consistency may be provided between each of the plurality of layers of stacked thin-film solar cells. A transparent conductive film such as a GZO (Ga-doped ZnO) film may be used as the intermediate contact layer.

The photovoltaic layer 13 need not be limited to silicon-based thin-film solar cells, and the invention can also be applied in a similar manner to compound semiconductor-based (CIS-type, CIGS-type or CdTe-type) solar cells.

Moreover, the term "silicon-based" is a generic term that includes silicon (Si), silicon carbide (SiC) and silicon germanium (SiGe).
Further, the term "crystalline silicon-based" describes a silicon system other than an amorphous silicon system, and includes both microcrystalline silicon systems and polycrystalline silicon systems.

The present embodiment describes the case in which the photovoltaic layer 13 is prepared by stacking an amorphous silicon p-layer 22A, an amorphous silicon i-layer 23A and an amorphous silicon n-layer 24A.
Moreover, the present embodiment describes the case in which the back electrode layer 14 is prepared by stacking a first back electrode layer 14A and a second back electrode layer 14B.

Fig. 4 is a schematic illustration describing a production process for the solar cell module of Fig. 2.
First, as illustrated in Fig. 4, a glass substrate is prepared as the transparent substrate 11A. A white crown glass substrate that exhibits excellent transmittance of light having a wavelength of 350 nm to 800 nm, which represents the absorption wavelength of the photovoltaic layer 13, is preferred. The edges of the transparent substrate 11A are preferably subjected to corner chamfering or R-face chamfering.

Fig. 5 is a schematic illustration describing a step of forming a transparent electrode layer in the production process for the solar cell module of Fig. 2.
As illustrated in Fig. 5, the transparent electrode layer 12 is deposited on the transparent substrate 11A using a thermal CVD apparatus at temperature conditions of approximately 500°C.
The transparent electrode layer 12 is a transparent electrode film comprising mainly tin oxide (SnO₂), and has a film thickness of approximately 500 nm to approximately 800 nm. During this deposition treatment, a texture comprising suitable asperity is formed on the surface of the tin oxide film.
The transparent electrode layer 12 may also be formed without using a thermal CVD apparatus, by using sputtering or the like to form a transparent conductive film comprising mainly zinc oxide (ZnO₂).

An alkali barrier film (not shown in the figure) may or may not be formed between the transparent substrate 11A and the transparent electrode layer 12, and there are no particular limitations in this regard.
The alkali barrier film is formed, for example, using a thermal CVD apparatus to deposit a silicon oxide film (SiO₂) at a temperature of approximately 500°C. The thickness of the silicon oxide film is typically approximately 50 nm to approximately 150 nm.

Fig. 6 is a schematic illustration describing a step of forming a transparent electrode layer slot in the production process for the solar cell module of Fig. 2.
As illustrated in Fig. 6, following deposition of the transparent electrode layer 12, a transparent electrode layer slot 15 is formed.
Specifically, the transparent substrate 11A is mounted on an X-Y table, and the first harmonic of a YAG laser (1064 nm) is irradiated onto the surface of the transparent electrode layer 12, as shown by the arrow in the figure. The transparent electrode layer 12 is laser-etched by the laser light, forming the transparent electrode layer slot 15 across a width of approximately 6 mm to 15 mm. This transparent electrode layer slot 15 partitions the transparent electrode layer 12 into strips.

The power of the irradiated YAG laser is adjusted to ensure an appropriate process speed for the transparent electrode layer slot 15. The laser light irradiated onto the transparent electrode layer 12 is moved relative to the transparent substrate 11A, in a direction perpendicular to the direction of the series connection of the electric power generation cells 2S (see Fig. 13).

Fig. 7 is a schematic illustration describing a step of stacking a photovoltaic layer in the production process for the solar cell module of Fig. 2.
As illustrated in Fig. 7, following formation of the transparent electrode layer slot 15, the photovoltaic layer 13 is stacked on the transparent electrode layer 12.
Specifically, using a plasma-enhanced CVD apparatus, and using SiH₄ gas and H₂ gas as the main raw materials, the photovoltaic layer 13 is deposited under conditions including a reduced pressure atmosphere within a range from approximately 30 Pa to approximately 1,000 Pa and a temperature for the transparent substrate 11A that is maintained at approximately 200°C. As illustrated in Fig. 2, the photovoltaic layer 13 comprises the amorphous silicon p-layer 22A, the amorphous silicon i-layer 23A and the amorphous silicon n-layer 24A stacked in that order, with the p-layer 22A closest to the surface from which the incident light such as sunlight enters the module.

The present embodiment describes the case in which the amorphous silicon p-layer 22A comprises mainly B-doped amorphous SiC and has a film thickness of approximately 10 nm to approximately 30 nm, the amorphous silicon i-layer 23A comprises mainly amorphous Si and has a film thickness of approximately 200 nm to approximately 350 nm, and the amorphous silicon n-layer 24A comprises mainly a P-doped silicon layer in which microcrystalline silicon is incorporated within amorphous silicon, and has a film thickness of approximately 30 nm to approximately 50 nm.
A buffer layer may be provided between the p-layer and the i-layer in order to improve the interface properties.

Fig. 8 is a schematic illustration describing a step of forming a connection groove in the production process for the solar cell module of Fig. 2.
As illustrated in Fig. 8, following stacking of the photovoltaic layer 13, a connection groove 17 is formed.
Specifically, the transparent substrate 11A is mounted on an X-Y table, and the second harmonic of a laser diode excited YAG laser (532 nm) is irradiated onto the surface of the photovoltaic layer 13, as shown by the arrow in the figure. The photovoltaic layer 13 is laser-etched, forming the connection groove 17.

Further, the laser light may be either irradiated from the side of the photovoltaic layer 13, or irradiated from the side of the transparent substrate 11A on the opposite side of the module, and there are no particular limitations in this regard.
In the case where irradiation is performed from the side of the transparent substrate 11A, the energy of the laser light is absorbed by the amorphous silicon layers of the photovoltaic layer 13, generating a high vapor pressure. This high vapor pressure can be utilized in etching the photovoltaic layer 13, meaning more stable laser etching processing can be performed.

The laser light is subjected to pulse oscillation within a range from approximately 10 kHz to approximately 20 kHz, and the laser power is adjusted so as to achieve a suitable process speed.
The position of the connection groove 17 is determined with due consideration of positioning tolerances, so as not to overlap with the transparent electrode layer slot 15 formed in a preceding step.

Fig. 9 and Fig. 10 are schematic illustrations describing a step of stacking a back electrode layer in the production process for the solar cell module of Fig. 2.
As illustrated in Fig. 9, following formation of the connection groove 17, the back electrode layer 14 is stacked on the photovoltaic layer 13. Specifically, the first back electrode layer 14A composed of a GZO film, and the second back electrode layer 14B composed of an Ag film and a Ti film, or an Ag film and an Al film, are stacked on the photovoltaic layer 13.
At this point, the back electrode layer 14 is also formed within the connection groove 17, forming a connection portion 18 that connects the transparent electrode layer 12 and the back electrode layer 14.

The first back electrode layer 14A is a Ga-doped ZnO film having a thickness of approximately 50 nm to approximately 100 nm, and is deposited using a sputtering apparatus.

The second back electrode layer 14B is deposited using a sputtering apparatus, under a reduced pressure atmosphere and under temperature conditions within a range from approximately 150°C to 200°C.
Specifically, an Ag film having a thickness within a range from approximately 150 nm to approximately 500 nm is deposited, and a Ti film having a thickness of approximately 10 nm to approximately 20 nm is then deposited on the Ag film. Alternatively, a stacked structure of an Ag film having a thickness of approximately 25 nm to 100 nm and an Al film having a thickness of approximately 15 nm to 500 nm may also be used.

As described above, by depositing the first back electrode layer 14A between the photovoltaic layer 13 (see Fig. 2) and the Ag film of the second back electrode layer 14B, the contact resistance between the photovoltaic layer 13 and the second back electrode layer 14B is reduced, and the degree of light reflection is improved.

Fig. 11 is a schematic illustration describing a step of producing an isolation groove in the production process for the solar cell module of Fig. 2.
As illustrated in Fig. 11, following stacking of the back electrode layer 14, an isolation groove 16 is formed.

Specifically, the transparent substrate 11A is mounted on an X-Y table, and the second harmonic of a laser diode excited YAG laser (532 nm) is irradiated through the transparent substrate 11A, as shown by the arrow in the figure. The irradiated laser light is absorbed by the photovoltaic layer 13, generating a high gas vapor pressure within the photovoltaic layer 13. This gas vapor pressure removes the first back electrode layer 14A and the second back electrode layer 14B by explosive fracture.
The laser light is subjected to pulse oscillation within a range from approximately 1 kHz to approximately 50 kHz, and the laser power is adjusted so as to achieve a suitable process speed.

Fig. 12 is a schematic illustration describing a step of producing an insulation slot in the production process for the solar cell module of Fig. 2. Fig. 13 is an illustration of the solar cell module viewed from the back electrode layer side, describing the formation of the insulation slot of Fig. 12.
As illustrated in Fig. 12 and Fig. 13, following formation of the isolation groove 16, an insulation slot 19 is formed. The insulation slot 19 compartmentalizes the electric power generation region, thereby isolating and removing the effects of the serially connected portions at the film edges near the edges of the transparent substrate 11A that are prone to short circuits.

Fig. 12 represents an X-direction cross-sectional view cut along the direction of the series connection of the photovoltaic layer 13, and therefore the location in the figure where the insulation slot 19 is formed should actually appear as a peripheral film removed region 20 in which the back electrode layer 14 (the first back electrode layer 14A and the second back electrode layer 14B), the photovoltaic layer 13 and the transparent electrode layer 12 have been removed by film polishing (see Fig. 13), but in order to facilitate description of the processing of the edges of the transparent substrate 11A, this location in the figure represents a Y-direction cross-sectional view, so that the formed insulation slot represents the X-direction insulation slot 19.

When forming the insulation slot 19, the transparent substrate 11A is mounted on an X-Y table, and the second harmonic of a laser diode excited YAG laser (532 nm) is irradiated through the transparent substrate 11A. The irradiated laser light is absorbed by the transparent electrode layer 12 and the photovoltaic layer 13, generating a high gas vapor pressure. This high gas vapor pressure removes the first back electrode layer 14A and the second back electrode layer 14B by explosive fracture, thus removing the back electrode layer 14 (the first back electrode layer 14A and the second back electrode layer 14B), the photovoltaic layer 13 and the transparent electrode layer 12.

The laser light is subjected to pulse oscillation within a range from approximately 1 kHz to approximately 50 kHz, and the laser power is adjusted so as to achieve a suitable process speed. The irradiated laser light is moved along the X-direction (see Fig. 13) at a position approximately 5 mm to 20 mm from the edge of the transparent substrate 11A.
At this point, a Y-direction insulation slot need not be provided, because a film surface polishing and removal treatment is conducted on the peripheral film removal region 20 of the transparent substrate 11A in a later step.

The insulation slot 19 is preferably formed at a position within a range from 5 mm to 15 mm from the edge of the transparent substrate 11A. By using this type of structure, external moisture can be inhibited from entering the interior of the solar cell module 2 via the edges of the solar cell panel.
Although the laser light used in the steps until this point has been specified as YAG laser light, the present invention is not limited to YAG lasers, and laser light from a YVO4 laser or fiber laser or the like may also be used in a similar manner.

Fig. 14 is a schematic illustration describing the stacking of a back substrate and the like on the transparent substrate of Fig. 13.
Following formation of the insulation slot 19, the stacked films are removed from the periphery of the transparent substrate 11A (a peripheral film removal region 20). Namely, the first back electrode layer 14A, the second back electrode layer 14B, the photovoltaic layer 13 and the transparent electrode layer 12 are removed to form the peripheral film removed region 20. These stacked films tend to be uneven and prone to peeling, and therefore removing these stacked films ensures more favorable bonding of the back substrate 11B via an encapsulant sheet 25 in a subsequent step, thus achieving a more favorable sealed surface.
The stacked films mentioned above are removed from a region that is within a range from 5 mm to 20 mm from the edge of the transparent substrate 11A, around the entire periphery of the transparent substrate 11A, thus forming the peripheral film removed region 20.

In the X-direction, the stacked films are removed from the region closer to the substrate edge than the above-mentioned insulation slot 19 using grinding or blast polishing or the like. On the other hand, in the Y-direction, the stacked films are removed from the region closer to the substrate edge than the transparent electrode layer slot 15 using grinding or blast polishing or the like.
Grinding debris or abrasive grains generated during removal of the stacked films are removed by washing the transparent substrate 11A.

A terminal access hole 11H is provided in the back substrate 11B in a location corresponding with an attachment portion for a terminal box 31, and collecting plates 22B and 23B are accessible through this terminal access hole 11H. A waterproofing material 21 may also be provided inside this terminal access hole 11H. Providing such a waterproofing material is preferable, as it facilitates suppression of heating effects generated during the bonding such as soldering of the terminal box 31 described below, and also inhibits penetration of external moisture or the like into the solar cell module.

By using a pressure-sensitive adhesive-coated heat-resistant film (such as Kapton tape, which is composed of a polyimide film coated with a pressure-sensitive adhesive) as the waterproofing material 21, heating effects on an insulation sheet 24 are inhibited during the bonding of the terminal box 31 to the copper foil terminals 22B and 23B by soldering or the like, which is described below. Further, if a laminated structure prepared by laminating a pressure-sensitive adhesive-coated aluminum foil and a pressure-sensitive adhesive-coated PET sheet to another pressure-sensitive adhesive-coated PET sheet is used as the waterproofing material 21, then the effect of the waterproofing material 21 in preventing the penetration of external moisture and the like into the module at the terminal access hole 11H can be further enhanced.

The waterproofing material 21 may be excluded in those cases where there are no problems associated with preventing penetration of external moisture and the like at the terminal access hole 11H, and in those cases where there are no problems associated with heating effects on the insulation sheet 24 during the bonding of the terminal box 31 and the copper foil terminals 22B and 23B by soldering or the like.

Copper foil terminals 22A and 23A having a pressure-sensitive adhesive provided on the surface that faces the back electrode layer 14 are attached, respectively, to the back electrode layer 14 of the solar cell electric power generation cell 2S at one end of the plurality of series-connected electric power generation cells 2S, and the back electrode layer 14 of the current collection cell connected to the transparent electrode layer 12 of the solar cell electric power generation cell 2S at the other end. Each of the copper foil terminals 22A and 23A is subjected to a surface texturing treatment such as embossing on the surface to which the pressure-sensitive adhesive is applied, which facilitates the bonding and securing of the terminal to the back electrode layer 14 via the pressure-sensitive adhesive, and also enables a favorable electrical connection to the back electrode layer 14 through the pressure-sensitive adhesive.

Using the copper foil terminals 22A, 22B that extend from the electric power generation cell 2S at one end, and the copper foil terminals 23A, 23B that extend from the current collection cell connected to the electric power generation cell 2S at the other end, the generated electric power is collected at the terminal box 31 disposed on the back substrate 11B.

A pressure-sensitive adhesive is provided on the surfaces of the copper foil terminals 22B, 23B facing the back electrode layer 14, but because electrical connection with the back electrode layer 14 is not necessary, the surfaces of the copper foil terminals 22B, 23B to which the pressure-sensitive adhesive is applied need not be subjected to a surface texturing treatment such as embossing.
The insulation sheet 24 is disposed between the copper foil terminals 22B, 23B and the back electrode layer 14 to prevent electrical short circuits. The insulation sheet 24 is formed, for example, as a broad sheet that is wider than the copper foil terminals 22B, 23B, using a resin having insulating properties such as PET (polyethylene terephthalate). Moreover, a pressure-sensitive adhesive is provided on the surface of the insulation sheet 24 that faces the back electrode layer 14, and this pressure-sensitive adhesive is used to affix the insulation sheet 24.

Further, at the portion where the copper foil terminal 22B and the copper foil terminal 22A make electrical contact, the copper foil terminal 22B is disposed between the copper foil terminal 22A and the back electrode layer 14, thus achieving good electrical contact. Similarly, at the portion where the copper foil terminal 23B and the copper foil terminal 23A make electrical contact, the copper foil terminal 23B is disposed between the copper foil terminal 23A and the back electrode layer 14, thus achieving good electrical contact.

An output cable 32 from the terminal box 31 is connected electrically to the copper foil terminals 22B, 23B by soldering or the like, generating a structure that enables the collected electric power to be extracted.
The copper foil terminals 22A, 22B, 23A, 23B are formed using oxygen-free copper or tough pitch copper, and are formed as a foil having a thickness of approximately 20 µm to approximately 50 µm. Oxygen-free copper has less self-retained oxygen than tough pitch copper, and therefore forming the copper foil terminals 22A, 22B, 23A, 23B using oxygen-free copper is preferred, as it inhibits oxidation of the copper foil terminals 22A, 22B, 23A, 23B and enables the durability of the terminals to be better maintained.

A heat-resistant acrylic pressure-sensitive adhesive or a heat-resistant silicon-based pressure-sensitive adhesive is used as the pressure-sensitive adhesive to ensure that the adhesive can withstand the temperature of approximately 150°C to approximately 160°C used during lamination treatment. By affixing the copper foil terminals 22A, 22B, 23A, 23B and the insulation sheet 24 in a simple manner using a pressure-sensitive adhesive, workability is improved, and the members can be affixed without gaps forming between the affixed members. Accordingly, potential paths through which moisture can penetrate into the interior of the solar cell module 2 can be blocked, resulting in superior effects.
Furthermore, instead of affixing the above members using a pressure-sensitive adhesive, the bonding portions may be affixed using EVA, and the electrical contact portions may be affixed using a silver paste or the like.

Following provision of the copper foil terminals 22A, 22B, 23A, 23B used for current collection, the encapsulant sheet 25 composed of EVA (ethylene-vinyl acetate copolymer) or the like and a peripheral sealing material 26 are provided.
The encapsulant sheet 25 covers the entire solar cell module 2, and is disposed in a region surrounded by the peripheral sealing material 26. As described above, each of the members such as the copper foil terminals 22A, 22B, 23A, 23B used in current collection are positioned sequentially on top of the photovoltaic layer 13 and the back electrode layer 14 formed on the transparent substrate 11A, and the back substrate 11B is then positioned on top of the encapsulant sheet 25.

The peripheral sealing material 26 is disposed on the edges of the transparent substrate 11A and the back substrate 11B, for example within the peripheral film removed region 20, and encapsulates the photovoltaic layer 13 and the like inside. A sealing material prepared using an elastic material such as butyl rubber can be used as the peripheral sealing material 26.

The back substrate 11B is installed on top of the encapsulant sheet 25.
The peripheral sealing material 26 prevents the encapsulant sheet 25 from protruding externally from between the transparent substrate 11A and the back substrate 11B, and also inhibits the penetration of moisture from the periphery of the solar cell module 2 into the interior.

Following arrangement of the encapsulant sheet 25, the peripheral sealing material 26 and the back substrate 11B in predetermined positions, a laminator is used to degas the area between the transparent substrate 11A and the back substrate 11B, and perform pressing at a temperature within a range from approximately 150°C to 160°C. This brings the back substrate 11B into close contact with the transparent substrate 11A, and causes cross-linking of the EVA of the encapsulant sheet 25, thereby bonding the back substrate 11B to the transparent substrate 11A.

The encapsulant sheet 25 is not limited to EVA, and an adhesive filler having similar functionality, such as PVB (polyvinyl butyral), may also be used. In such a case, the conditions employed such as the pressure bonding sequence, the temperature and the bonding time are optimized for the adhesive filler being used.

Fig. 15 is a schematic illustration describing a step of attaching a terminal box in the production process for the solar cell module of Fig. 2. Fig. 16 is a schematic illustration describing a sealing step in the production process for the solar cell module of Fig. 2.
As illustrated in Fig. 15, following bonding of the back substrate 11B, the terminal box 31 is attached to the back surface of the solar cell module 2 using an adhesive.
Subsequently, the copper foil terminals 22B, 23B are connected electrically to the output cable 32 from the terminal box 31 using solder or the like, and the interior of the terminal box 31 is then filled and sealed with a sealant (a potting material).

Fig. 17 is a schematic illustration describing a step of attaching long-side ribs and short-side ribs to the solar cell module.
As illustrated in Fig. 17, following completion of the attachment of the terminal box 31, the long-side ribs 3L and the short-side ribs 3S are attached to the solar cell module 2.

The pair of long-side ribs 3L and the pair of short-side ribs 3S are fastened together using the rib bolts 3B to form a rectangular-shaped structure. Double-sided tape 3T is stuck to the back substrate 11B of the solar cell module 2 in positions that contact the long-side ribs 3L and the short-side ribs 3S, and this double-sided tape 3T and an adhesive (not shown in the figure) are used to affix the long-side ribs 3L and the short-side ribs 3S to the back substrate 11B of the solar cell module 2. The long-side ribs 3L and the short-side ribs 3S may be affixed using only an adhesive, but by also using the double-sided tape 3T, affixing the long-side ribs 3L and the short-side ribs 3S in the required bonding positions is simplified.
This completes the production of the solar cell panel 1.

There are no particular limitations on whether the double-sided tape 3T is stuck to the back substrate 11B, and the long-side ribs 3L and the short-side ribs 3S are then affixed to the back substrate 11B in the manner described above, or whether the double-sided tape 3T is stuck to the long-side ribs 3L and the short-side ribs 3S, and the long-side ribs 3L and the short-side ribs 3S are then affixed to the back substrate 11B.

According to the structure described above, the solar cell panel 1 is reinforced by bonding the long-side ribs 3L and the short-side ribs 3S to the back substrate 11B. As a result, the long-side ribs 3L and the short-side ribs 3S can function as members (strengthening members) that impart strength to the solar cell module 2, relative to loads that include both positive pressure caused by loads imparted to the light-incident surface of the solar cell panel 1 by wind blown onto the surface or snow accumulation on the surface, and negative pressure resulting from wind pressure due to wind blown onto the solar cell panel 1 from the opposite surface to the light-incident surface.

Accordingly, compared with the case where the long-side ribs 3L and the short-side ribs 3S are not used, by bonding the simply shaped and lightweight long-side ribs 3L and short-side ribs 3S directly to the back substrate 11B, the strength of the solar cell panel 1 can be increased. As a result, the strength of the back substrate 11B itself may be quite low, enabling the thickness of the back substrate 11B to be reduced, and enabling reductions in the production costs and weight of the back substrate 11B. As a result, the material costs for the back substrate 11B can be reduced, meaning the production costs of the solar cell panel 1 can also be reduced.

Moreover, by reducing the thickness of the back substrate 11B, the mass of the solar cell panel 1 can be reduced to produce a more lightweight structure, even allowing for the mass increase resulting from the long-side ribs 3L and the short-side ribs 3S, which improves handling of the solar cell panel 1 during production and installation.

The fixture 4 presses down on the flanges 3F of the long-side ribs 3L, thereby affixing the solar cell panel 1 to a mount (an installation surface such as the mounting structure 5), and therefore there is no need to sandwich or press down upon the solar cell module 2 itself, and in particular the transparent substrate 11A and the back substrate 11B. As a result, during fixing of the solar cell panel 1 to the mount (an installation surface such as the mounting structure 5), no load is paced on the transparent substrate 11A or the back substrate 11B, meaning any damage to the two substrates, and particularly the edge portions of the two substrates, can be prevented, and the solar cell panel 1 can be attached and secured to the mount in a relatively simple manner.

There are no particular limitations on the numbers of the long-side ribs 3L and the short-side ribs 3S, and the solar cell module 2 may be supported solely with the pair of long-side ribs 3L, 3L and the pair of short-side ribs 3S, 3S, as in the embodiment described above, or an additional short-side rib 3S may be provided between the pair of short-side ribs 3S, 3S, so that the solar cell module 2 is supported by a total of three short-side ribs 3S and the pair of long-side ribs 3L, 3L.

By using the type of structure described above, even in those cases where the installation configuration means that a higher load is placed on the solar cell panel 1, satisfactory support of the solar cell module 2 can be achieved without altering the thicknesses of the transparent substrate 11A and the back substrate 11B, and without altering the cross-sectional shapes of the long-side ribs 3L and the short-side ribs 3S. In other words, the solar cell panel 1 can easily be altered to a design capable of withstanding a large load, and managing the production and assembly of the panel in the factory is also comparatively simple.
Examples of cases where a large load may be placed on the solar cell panel 1 include cases where the solar cell panel 1 is installed in snow-covered regions, and cases where the solar cell panel 1 is installed in locations exposed to large wind pressures, such as high-rise buildings.

### First Embodiment

A first embodiment of the present invention is described below with reference to Fig. 18 to Fig. 21.
The basic structure of the solar cell panel of this embodiment is the same as that of the reference embodiment described above, but the structures of the long-side ribs and the short-side ribs and the like that support the solar cell module differ from those of the reference embodiment. Accordingly, for the present embodiment, the structures of the long-side ribs and the short-side ribs and the like are described using Fig. 18 to Fig. 21, whereas descriptions of the other structural elements and the like are omitted.
Fig. 18 is a schematic illustration describing the structures of the long-side ribs, the short-side ribs and protective ribs for a solar cell panel according to the present embodiment.
Those structural elements that are the same as elements within the reference embodiment are labeled using the same reference signs, and their descriptions are omitted.

As illustrated in Fig. 18, a solar cell panel 101 of the present embodiment comprises the solar cell module 2, a pair of long-side ribs (first protective ribs) 103L, 103L, the pair of short-side ribs (support ribs) 3S, 3S, and a pair of protective ribs (second protective ribs) 104P, 104P.

As illustrated in Fig. 18, the pair of long-side ribs 103L, 103L and the pair of short-side ribs 3S, 3S are bonded and affixed to the back substrate 11B of the solar cell module 2, thereby supporting the solar cell module 2. Moreover, the pair of long-side ribs 103L, 103L and the pair of short-side ribs 3S, 3S are formed from a metal material such as aluminum or an aluminum alloy, and reinforce the strength of the back substrate 11B. The pair of protective ribs 104P, 104P are also formed from a metal material such as aluminum or an aluminum alloy. In those cases where the pair of protective ribs 104P, 104P need not exhibit strength, a resin material such as a vinyl-based or plastic-based material may also be used.

Fig. 19 is a cross-sectional view describing the structure of a long-side rib from Fig. 18. Fig. 20 is a schematic illustration describing a state in which the solar cell module is supported on a long-side rib from Fig. 18.
The long-side rib 103L supports the solar cell module 2, as well as protecting the long-side edges of the transparent substrate 11A and the back substrate 11B of the solar cell module 2.
As illustrated in Fig. 19 and Fig. 20, the long-side rib 103L comprises a flange 103F, a long-side contact portion (contact portion) 103C, and a long-side protective wall (protective wall) 103W.

In a similar manner to the flange 3F in the reference embodiment, the flange 103F is used when affixing the solar cell panel 1 to a mounting structure 5 of a mount. The flange 103F is a plate-like member that extends in a direction substantially parallel to the solar cell module 2 and the long-side contact portion 103C, and is formed as part of an integral unit that is linked with the long-side contact portion 103C via a plate-like member that is aligned substantially perpendicularly to the flange 103F.

The long-side contact portion 103C is a plate-like member that contacts the back substrate 11B of the solar cell module 2 and extends in a direction substantially parallel to the back substrate 11B. Moreover, the long-side contact portion 103C extends from the long-side edges of the transparent substrate 11A and the back substrate 11B toward the inside of the solar cell module 2.
The long-side contact portion 103C is bonded and affixed to the back substrate 11B using adhesive means such as a butyl rubber-based adhesive or a double-sided tape.

The long-side protective wall 103W is a plate-like member that protects the edges of the transparent substrate 11A and the back substrate 11B of the solar cell module 2.
The long-side protective wall 103W extends from the outside edge of the long-side contact portion 103C along the edge of the solar cell module 2, in a direction from the back substrate 11B toward the transparent substrate 11A, although the tip of the long-side protective wall 103W does not protrude beyond the surface of the transparent substrate 11A. Moreover, the long-side protective wall 103W is formed with a shape that narrows in thickness in the direction from the back substrate 11B toward the transparent substrate 11A, namely a tapered cross-sectional shape.

Fig. 21 is a schematic illustration describing a state in which the solar cell module is supported on a protective rib from Fig. 18.
The protective ribs 104P are a pair of ribs that are disposed across the space between the pair of long-side ribs 103L, and extend along the short-side edges of the back substrate 11B. Moreover, the protective ribs 104P differ from the short-side ribs 3S in that they protect the short-side edges of the solar cell module 2, and are not provided for the purpose of structurally supporting the solar cell module 2.
As illustrated in Fig. 21, the protective rib 104P comprises a protective contact portion (contact portion) 104C, a protective wall 104W and a securing boss 104B.

The protective contact portion 104C is a plate-like member that contacts the back substrate 11B of the solar cell module 2 and extends in a direction substantially parallel to the back substrate 11B. Moreover, the protective contact portion 104C extends outward beyond the short-side edges of the transparent substrate 11A and the back substrate 11B.
The protective contact portion 104C is bonded and affixed to the back substrate 11B using adhesive means such as a butyl rubber-based adhesive or a double-sided tape.

The protective wall 104W is a plate-like member that protects the edges of the transparent substrate 11A and the back substrate 11B of the solar cell module 2.
The protective wall 104W extends from the outside edge of the protective contact portion 104C along the edge of the solar cell module 2, in a direction from the back substrate 11B toward the transparent substrate 11A, although the tip of the protective wall 104W does not protrude beyond the surface of the transparent substrate 11A. Moreover, the protective wall 104W is formed with a shape that narrows in thickness in the direction from the back substrate 11B toward the transparent substrate 11A, namely a tapered cross-sectional shape.

The securing boss 104B is used, together with the rib bolt 3B, for securing the protective rib 104P to the long-side rib 103L, and includes an internal female thread that matches and engages with the male thread of the rib bolt 3B.

By adopting the configuration described above, the long-side ribs 103L and the protective ribs 104P protrude beyond the outside edges of the solar cell module 2, and therefore even if an edge of the solar cell panel 101 is bumped, the long-side contact portion 103C, the long-side protective wall 103W, the protective contact portion 104C or the protective wall 104W makes contact before the edge of the transparent substrate 11A or the back substrate 11B. As a result, damage to the edge portions of the solar cell panel 101 can be prevented.

Moreover, in the case of a large solar cell panel having a surface area exceeding 1 m², because the mass of the panel can exceed 20 kg, making handling difficult, bumping of the edge portions of the solar cell panel 101 during production or installation becomes more likely. However, with the present embodiment, damage to the edge portions can be prevented, meaning the panel can be handled with improved peace of mind.

Moreover, the long-side protective wall 103W and the protective wall 104W protrude toward the solar cell module 2 from the long-side contact portion 103C and the contact portion 104C respectively, covering the edges of the solar cell module 2 (the edges of the transparent substrate 11A and the back substrate 11B), and therefore compared with the case where only the long-side contact portion 103C and the contact portion 104C are provided, the edges of the solar cell module 2 can be protected with greater reliability.

On the other hand, providing the long-side protective wall 103W on the long-side rib 103L increases the cross-sectional secondary moment of the long-side rib 103L. Accordingly, the strength of the long-side rib 103L increases, contributing to an increase in the strength of the solar cell panel 101.

By forming the long-side protective wall 103W of the long-side rib 103L and the protective wall 104W of the protective rib 104P with a tapered cross-sectional shape, the weight of the long-side rib 103L and the protective rib 104P can be reduced compared with the case where the cross-sectional shape has a uniform thickness.
By securing the protective ribs 104P and the long-side ribs 103L using the rib bolts 3B, the long-side ribs 103L, the short-side ribs 3S and the protective ribs 104P can be assembled with comparative ease.

Because the tip of the long-side protective wall 103W and the tip of the protective wall 104W do not protrude beyond the surface of the transparent substrate 11A, a level difference is not formed around the periphery of the sunlight-incident surface of the solar cell module 2 when the solar cell panel 101 is installed on an inclined surface. As a result, moisture and dust does not accumulate on the low side of the inclined surface of the solar cell module 2, meaning the incident light is not blocked, and no reduction occurs in the electric power generation surface area.

The long-side ribs 103L and the short-side ribs 3S support the solar cell module 2 as in the embodiment described above, but there are no particular limitations on whether the long-side ribs 103L protect the long-side edges of the solar cell module 2 and the protective ribs 104P protect the short-side edges of the solar cell module 2, or whether the protective ribs protect the long-side edges of the solar cell module 2 and the short-side ribs protect the short-side edges of the solar cell module 2.

### First modified example of the first embodiment

Next is a description of a first modified example of the first embodiment of the present invention, with reference to Fig. 22 and Fig. 23. The basic structure of the solar cell panel of this modified example is the same as that of the first embodiment, but the structures of the long-side ribs and the protective ribs differ from those of the first embodiment. Accordingly, for this modified example, the structures of the long-side ribs and the protective ribs are described using Fig. 22 and Fig. 23, whereas descriptions of the other structural elements and the like are omitted.
Fig. 22 is a cross-sectional view describing the structure of a long-side rib of a solar cell panel according to this modified example. Fig. 23 is a cross-sectional view describing the structure of a protective rib of a solar cell panel according to this modified example.
Those structural elements that are the same as elements within the first embodiment are labeled using the same reference signs, and their descriptions are omitted.

As illustrated in Fig. 22 and Fig. 23, a solar cell panel 201 of this modified example comprises mainly the solar cell module 2, a pair of long-side ribs (first protective ribs) 203L, 203L, and a pair of protective ribs (second protective ribs) 204P, 204P.

As illustrated in Fig. 22, the pair of long-side ribs 203L, 203L are formed from a metal material such as aluminum or an aluminum alloy, and reinforce the strength of the back substrate 11B. As illustrated in Fig. 23, the pair of protective ribs 204P, 204P are also formed from a metal material such as aluminum or an aluminum alloy. In those cases where the pair of protective ribs 204P, 204P need not exhibit strength, a resin material such as a vinyl-based or plastic-based material may also be used.

The long-side ribs 203L support the solar cell module 2, as well as protecting the long-side edges of the transparent substrate 11A and the back substrate 11B of the solar cell module 2.
As illustrated in Fig. 22, the long-side rib 203L comprises the flange 103F, the long-side contact portion 103C, and a long-side protective wall (the protective wall) 203W.

The long-side protective wall 203W is a plate-like member that protects the transparent substrate 11A and the back substrate 11B of the solar cell module 2.
The long-side protective wall 203W extends from the outside edge of the long-side contact portion 103C, in a direction away from the solar cell module 2, namely in a direction from the transparent substrate 11A toward the back substrate 11B. Moreover, the long-side protective wall 203W is formed with a shape that narrows in thickness in the direction from the transparent substrate 11A toward the back substrate 11B, namely a tapered cross-sectional shape.

The protective ribs 204P are a pair of ribs that are disposed across the space between the pair of long-side ribs 203L, and extend along the short-side edges of the back substrate 11B. Moreover, the protective ribs 204P differ from the short-side ribs 3S in that they protect the short-side edges of the solar cell module 2, and are not provided for the purpose of structurally supporting the solar cell module 2.
As illustrated in Fig. 23, the protective rib 204P comprises the protective contact portion 104C, a protective wall 204W and the securing boss 104B.

The protective wall 204W is a plate-like member that protects the edges of the transparent substrate 11A and the back substrate 11B of the solar cell module 2.
The protective wall 204W extends from the outside edge of the protective contact portion 104C, in a direction away from the solar cell module 2, namely in a direction from the transparent substrate 11A toward the back substrate 11B. Moreover, the protective wall 204W is formed with a shape that narrows in thickness in the direction from the transparent substrate 11A toward the back substrate 11B, namely a tapered cross-sectional shape.

By adopting the configuration described above, the long-side ribs 203L and the protective ribs 204P protrude beyond the outside edges of the solar cell module 2, and therefore even if an edge of the solar cell panel 201 is bumped, the long-side contact portion 103C, the long-side protective wall 203W, the protective contact portion 104C or the protective wall 204W makes contact before the edge of the transparent substrate 11A or the back substrate 11B. As a result, damage to the edge portions of the solar cell panel 201 can be prevented.

### Second modified example of the first embodiment

Next is a description of a second modified example of the first embodiment of the present invention, with reference to Fig. 24 and Fig. 25.
The basic structure of the solar cell panel of this modified example is the same as that of the first embodiment, but the structures of the long-side ribs and the protective ribs differ from those of the first embodiment. Accordingly, for this modified example, the structures of the long-side ribs and the protective ribs are described using Fig. 24 and Fig. 25, whereas descriptions of the other structural elements and the like are omitted.
Fig. 24 is a cross-sectional view describing the structure of a long-side rib of a solar cell panel according to this modified example. Fig. 25 is a cross-sectional view describing the structure of a protective rib of a solar cell panel according to this modified example.
Those structural elements that are the same as elements within the first embodiment are labeled using the same reference signs, and their descriptions are omitted.

As illustrated in Fig. 24 and Fig. 25, a solar cell panel 301 of this modified example comprises mainly the solar cell module 2, a pair of long-side ribs (first protective ribs) 303L, 303L, and a pair of protective ribs (second protective ribs) 304P, 304P.

As illustrated in Fig. 24, the pair of long-side ribs 303L, 303L are formed from a metal material such as aluminum or an aluminum alloy, and reinforce the strength of the back substrate 11B. As illustrated in Fig. 25, the pair of protective ribs 304P, 304P are also formed from a metal material such as aluminum or an aluminum alloy. In those cases where the pair of protective ribs 304P, 304P need not exhibit strength, a resin material such as a vinyl-based or plastic-based material may also be used.

The long-side ribs 303L support the solar cell module 2, as well as protecting the long-side edges of the transparent substrate 11A and the back substrate 11B of the solar cell module 2.
As illustrated in Fig. 24, the long-side rib 303L comprises the flange 103F and a long-side contact portion (contact portion) 303C.

The long-side contact portion 303C is a plate-like member that contacts the back substrate 11B of the solar cell module 2 and extends in a direction substantially parallel to the back substrate 11B. Moreover, the long-side contact portion 303C extends from the long-side edges of the transparent substrate 11A and the back substrate 11B beyond the outside edge of the solar cell module 2.
The long-side contact portion 303C is bonded and affixed to the back substrate 11B using adhesive means such as a butyl rubber-based adhesive or a double-sided tape.

The protective ribs 304P are a pair of ribs that are disposed across the space between the pair of long-side ribs 303L, and extend along the short-side edges of the back substrate 11B. Moreover, the protective ribs 304P differ from the short-side ribs 3S in that they protect the short-side edges of the solar cell module 2, and are not provided for the purpose of structurally supporting the solar cell module 2.
As illustrated in Fig. 25, the protective rib 304P comprises a protective contact portion (contact portion) 304C and the securing boss 104B.

The protective contact portion 304C is a plate-like member that contacts the back substrate 11B of the solar cell module 2 and extends in a direction substantially parallel to the back substrate 11B. Moreover, the protective contact portion 304C extends outward from the short-side edges of the transparent substrate 11A and the back substrate 11B.
The protective contact portion 304C is bonded and affixed to the back substrate 11B using adhesive means such as a butyl rubber-based adhesive or a double-sided tape.

By adopting the configuration described above, the long-side ribs 303L and the protective ribs 304P protrude beyond the outside edges of the solar cell module 2, and therefore even if an edge of the solar cell panel 301 is bumped, the long-side contact portion 303C or the protective contact portion 304C makes contact before the edge of the transparent substrate 11A or the back substrate 11B. As a result, damage to the edge portions of the solar cell panel 301 can be prevented.

### Second embodiment

A second embodiment of the present invention is described below with reference to Fig. 26 and Fig. 29.
The basic structure of the solar cell panel of this embodiment is the same as that of the first embodiment described above, but the structures at those portions where the long-side ribs and the protective ribs are connected to the solar cell module differ from those of the first embodiment. Accordingly, for the present embodiment, the structures at these portions where the long-side ribs and the protective ribs are connected to the solar cell module are described using Fig. 26 and Fig. 29, whereas descriptions of the other structural elements and the like are omitted.
Fig. 26 is a cross-sectional view describing the structure of a long-side rib of a solar cell panel according to the present embodiment. Fig. 29 is a cross-sectional view describing the structure of a protective rib of a solar cell panel according to the present embodiment.
Those structural elements that are the same as elements within the first embodiment are labeled using the same reference signs, and their descriptions are omitted.

As illustrated in Fig. 26 and Fig. 29, a solar cell panel 401 of the present embodiment comprises mainly the solar cell module 2, the pair of long-side ribs 103L, 103L, the pair of protective ribs 104P, 104P, and a rib sealing material (sealing material) 405.

The rib sealing material 405 improves the waterproofing performance around the periphery of the solar cell panel 401, and also improves the adhesive strength between the solar cell module 2, and the long-side ribs 103L and the protective ribs 104P. The rib sealing material 405 is disposed in spaces between the solar cell module 2 and the long-side ribs 103L, and in spaces between the solar cell module 2 and the protective ribs 104P, and is composed of a silicon-based adhesive, a butyl rubber-based adhesive or a hot melt material.

Specifically, the rib sealing material 405 is used to fill the space between the long-side protective wall 103W of the long-side rib 103L, and the edge of the transparent substrate 11A, the edge of the back substrate 11B and the peripheral sealing material 26 of the solar cell module 2. Moreover, the rib sealing material 405 may also be used to fill gaps at the bonding surface between the long-side contact portion 103C and the back substrate 11B. Similarly, the rib sealing material 405 is used to fill the space between the protective wall 104W of the protective rib 104P, and the edge of the transparent substrate 11A, the edge of the back substrate 11B and the peripheral sealing material 26 of the solar cell module 2, and may also be used to fill gaps at the bonding surface between the protective contact portion 104C and the back substrate 11B.

By adopting the configuration described above, the rib sealing material 405 is disposed in the spaces between the peripheral edges of the solar cell module 2 and the long-side ribs 103L and protective ribs 104P, enabling an improvement in the waterproofing performance at the edge portions of the solar cell module 2.
In addition, the adhesive strength between the long-side ribs 103L and protective ribs 104P and the solar cell module 2 can be improved compared with the case where the rib sealing material 405 is not used.

Moreover, because the rib sealing material 405 exhibits elasticity, the cushioning effect between the long-side ribs 103L and protective ribs 104P and the edge portions of the solar cell module 2 can be enhanced compared with the case where the rib sealing material 405 is not used, enabling better prevention of damage to the edge portions of the solar cell panel 401.

### Modified examples of the second embodiment

Next is a description of modified examples of the second embodiment of the present invention, with reference to Fig. 27, Fig. 28, Fig. 30 and Fig. 31.
The basic structure of the solar cell panels of these modified examples is the same as that of the second embodiment, but the position of the rib sealing material relative to the structures of the long-side ribs and the protective ribs differs from the position employed within the second embodiment. Accordingly, for these modified examples, only the structures of the long-side ribs and the protective ribs and the positioning of the rib sealing material are described, whereas descriptions of the other structural elements and the like are omitted.
The long-side ribs and the protective ribs are the same as those described for the first modified example of the first embodiment (see Fig. 22 and Fig. 23) and the second modified example of the first embodiment (see Fig. 24 and Fig. 25).

Specifically, the rib sealing material 405 is used to fill the space connecting the long-side contact portion 103C or the long-side contact portion 303C of the long-side rib 203L or 303L, and the edge of the transparent substrate 11A, the edge of the back substrate 11B and the peripheral sealing material 26 of the solar cell module 2. Moreover, the rib sealing material 405 may also be used to fill gaps at the bonding surface between the long-side contact portion 103C or the long-side contact portion 303C and the back substrate 11B.

Similarly, the rib sealing material 405 is used to fill the space connecting the protective contact portion 104C or the protective contact portion 304C of the protective rib 204P or the protective rib 304P, and the edge of the transparent substrate 11A, the edge of the back substrate 11B and the peripheral sealing material 26 of the solar cell module 2. Moreover, the rib sealing material 405 may also be used to fill gaps at the bonding surface between the protective contact portion 104C or the protective contact portion 304C and the back substrate 11B.

In the configuration described above, a conventional tool such as a dispenser can be used to apply the rib sealing material 405 in the spaces connecting the peripheral edges of the solar cell module 2, and the long-side ribs 203L or long-side ribs 303L and the protective ribs 204P or protective ribs 304P. Further, by providing the rib sealing material 405, the waterproofing performance at the edge portions of the solar cell module 2 can be improved.

In addition, the adhesive strength between the long-side ribs 203L or long-side ribs 303L and the protective ribs 204P or protective ribs 304P, and the solar cell module 2 can be improved compared with the case where the rib sealing material 405 is not used.

Moreover, because the rib sealing material 405 exhibits elasticity, the cushioning effect between the edge portions of the solar cell module 2 and external contact items that are bumped during handling of the solar cell panels 201 or 301 can be enhanced compared with the case where the rib sealing material 405 is not used. In other words, the cushioning effect between the long-side ribs 203L or protective ribs 304P that make contact with the external contact items, and the edge portions of the solar cell module 2 can be enhanced. As a result, damage to the edge portions of the solar cell panels 201 or 301 can be prevented.

### Third embodiment

A third embodiment of the present invention is described below with reference to Fig. 32.
The basic structure of the solar cell panel of this embodiment is the same as that of the first embodiment, but the method used for bonding the solar cell module to the long-side ribs and the like differs from that of the first embodiment. Accordingly, for the present embodiment, only the method used for bonding the solar cell module to the long-side ribs and the like is described using Fig. 32, whereas descriptions of the other structural elements and the like are omitted.
Fig. 32 is a schematic illustration describing a method of bonding a solar cell panel to a long-side rib for a solar cell panel according to the present embodiment.
Those structural elements that are the same as elements within the first embodiment are labeled using the same reference signs, and their descriptions are omitted.

As illustrated in Fig. 32, sections of a rib double-sided tape (double-sided tape) 502, 502 and a rib adhesive (adhesive) 503 are provided between the solar cell module 2 and the long-side rib 103L of a solar cell panel 501 of the present embodiment.

The rib double-sided tape 502 and the rib adhesive 503 may be used not only for bonding the solar cell module 2 to the long-side ribs 103L, but also for bonding the solar cell module 2 to the short-side ribs 3S, and bonding the solar cell module 2 to the protective ribs 104P. In order to facilitate understanding of this embodiment, only the bonding of the solar cell module 2 to the long-side rib 103L is described below.

The rib double-sided tape 502 is used, together with the rib adhesive 503, for bonding the solar cell module 2 and the long-side rib 103L. Moreover, the rib double-sided tape 502 is disposed in a lengthwise direction along the long-side contact portion 103C that acts as the contact surface of the long-side rib 103L, and is provided in sections along the edges of the long-side contact portion 103C, so as to sandwich the rib adhesive 503 therebetween.
There are no particular limitations on the rib double-sided tape 502, and conventional double-sided tapes can be used.

The rib adhesive 503 is used, together with the rib double-sided tape 502, for bonding the solar cell module 2 and the long-side rib 103L. The rib adhesive 503 is disposed on the long-side contact portion 103C, and is disposed in a region that is sandwiched between sections of the rib double-sided tape 502.
Examples of adhesives that may be used as the rib adhesive 503 include urethane one-pot adhesives and silicon-based two-pot adhesives.

Specifically, sections of the rib double-sided tape 502 are stuck to the long-side contact portion 103C, and the rib adhesive 503 is then applied to the region sandwiched between the sections of the rib double-sided tape 502. Subsequently, the long-side contact portion 103C is pressed against the back substrate 11B of the solar cell module 2.
By employing this method, the solar cell module 2 and the long-side rib 103L are temporarily secured with the rib double-sided tape 502 until the curing period of the rib adhesive 503 has elapsed. Following curing, the rib adhesive 503 secures the solar cell module 2 and the long-side rib 103L.

According to the configuration described above, the long-side rib 103L, the short-side rib 3S or the protective rib 104P can be positioned more easily relative to the back substrate 11B than the case where the two members are bonded using only the rib adhesive 503, and the two members need not be secured until the adhesive curing period has elapsed, meaning the bonding process is simplified.

Moreover, the thickness of the rib double-sided tape 502 maintains a space between the two members for the layer of the rib adhesive 503, ensuring an adhesive layer thickness that is capable of providing good adhesive performance. The thickness of the layer of the rib adhesive 503 that is required for providing good adhesive performance varies depending on the adhesive used, but is preferably within a range from approximately 0.5 mm to 2.0 mm, and is more preferably within a range from approximately 1.0 mm to 1.5 mm.

By positioning the rib double-sided tape 502 along the edge regions of the long-side contact portion 103C, and then disposing the rib adhesive 503 between the sections of the tape, leakage of the rib adhesive 503 outside the long-side contact portion 103C is prevented.

As a result, the rib adhesive 503 does not leak into the spaces between the back substrate 11B and the long-side rib 103L, the short-side rib 3S or the protective rib 104P, meaning any potential deterioration in the external appearance can be prevented. Moreover, accumulation of water within gaps in any leaked rib adhesive 503 can also be prevented, meaning the reliability of the solar cell panel 501 can be improved.

Further, compared with the case where the long-side rib 103L, the short-side rib 3S or the protective rib 104P is bonded and secured using only the rib double-sided tape 502, the long-term reliability of the adhesive strength can be improved. The rib double-sided tape 502 is disposed along the lengthwise direction of the long-side contact portion 103C of the long-side rib 103L, but need not necessarily be a continuous section of tape. There is a possibility that small amounts of the rib adhesive 503 may leak through gaps in the rib double-sided tape 502, but provided the gaps are small, any adverse effects on the external appearance or the like are minimal, and no particular problems arise.

Compared with the case where the long-side rib 103L, the short-side rib 3S or the protective rib 104P is bonded and affixed to the back substrate 11B using only the rib double-sided tape 502, the amount of the rib double-sided tape 502 used can be reduced, the production costs can be reduced, and the durability of the resulting structure can be improved.

### Fourth embodiment

A fourth embodiment of the present invention is described below with reference to Fig. 33 and Fig. 34.
The basic structure of the solar cell panel of this embodiment is the same as that of the first embodiment, but the method used for bonding the solar cell module to the long-side ribs and the like differs from that of the first embodiment. Accordingly, for the present embodiment, only the method used for bonding the solar cell module to the long-side ribs and the like is described using Fig. 33 and Fig. 34, whereas descriptions of the other structural elements and the like are omitted.
Fig. 33 is a schematic illustration describing a method of bonding a solar cell panel to a long-side rib for a solar cell panel according to the present embodiment. Fig. 34 is a perspective view describing the structures of the long-side rib and the spacer from Fig. 33.
Those structural elements that are the same as elements within the first embodiment are labeled using the same reference signs, and their descriptions are omitted.

As illustrated in Fig. 33 and Fig. 34, a rib spacer (spacer) 604 and the rib adhesive 503 are provided between the solar cell module 2 and a long-side rib (first protective rib) 603L of a solar cell panel 601 of the present embodiment.

The rib spacer 604 and the rib adhesive 503 may be used not only for bonding the solar cell module 2 to the long-side ribs 603L, but also for bonding the solar cell module 2 to the short-side ribs 3S, and bonding the solar cell module 2 to the protective ribs 104P. In order to facilitate understanding of this embodiment, only the bonding of the solar cell module 2 to the long-side rib 603L is described below.

As illustrated in Fig. 33 and Fig. 34, the long-side rib 603L supports the solar cell module 2, and also protects the long-side edges of the transparent substrate 11A and the back substrate 11B of the solar cell module 2. The long-side rib 603L is formed from a metal material such as aluminum or an aluminum alloy, and reinforces the strength of the back substrate 11B.
The long-side rib 603L comprises the flange 103F, a long-side contact portion (contact portion) 603C, and the long-side protective wall 103W.

The long-side contact portion 603C is a plate-like member that contacts the back substrate 11B of the solar cell module 2, and extends in a direction substantially parallel to the back substrate 11B. Moreover, the long-side contact portion 603C extends outward from the long-side edges of the transparent substrate 11A and the back substrate 11B.

In the long-side contact portion 603C, a channel 603G inside which the rib spacer 604 is disposed extends along the lengthwise direction of the long-side rib 603L. The channel 603G is formed in substantially the center of the long-side contact portion 603C, so that the rib adhesive 503 can be applied in regions along both sides of the channel 603G. Moreover, in order to ensure that the rib spacer 604 cannot easily disengage, the channel 603G is formed with an L-shaped cross-section. In other words, the channel 603G is formed with a cross-sectional shape having a narrow opening and a broader interior.

The rib spacer 604 determines the spacing between the solar cell module 2 and the long-side rib 603L. The rib spacer 604 is formed with a J-shaped or Z-shaped cross-section. There are no particular limitations on the length of the rib spacer 604, which may be the same as the length in the lengthwise direction of the long-side rib 603L in which the spacer is engaged, or may be shorter.
The present embodiment is described using the case where the rib spacer 604 is formed from a resin such as a plastic, but the present invention is not necessarily limited to this case.

The rib spacer 604 comprises mainly an upper portion 604U that is exposed above the surface of the long-side contact portion 603C, and a lower portion 604L that is engaged within the channel 603G.
The upper portion 604U is formed with a plate-like shape, and the thickness of this upper portion 604U determines the spacing between the solar cell module 2 and the long-side rib 603L.
Although the thickness of the layer of the rib adhesive 503 between the back substrate 11B and the long-side contact portion 603C that best enables the layer to be retained and a good adhesive performance to be achieved varies depending on the variety of adhesive used, the thickness is preferably within a range from approximately 0.5 mm to 2.0 mm, and more preferably within a range from approximately 1.0 mm to 1.5 mm. The present embodiment is described for the case in which the thickness of the upper portion 604U is approximately 1 mm.

The lower portion 604L is the portion that engages within the channel 603G, and can be formed in any manner of shape that matches the shape of the channel 603G. Further, the channel 603G is preferably of a size that provides appropriate clearance for the spacer, allowing the rib spacer 604 to be engaged smoothly, but without producing any significant rattle.

The solar cell module 2 is positioned in a work location with the back substrate 11B facing upward. The long-side rib 603L having the rib spacer 604 engaged within the channel 603G and having the rib adhesive 503 applied to the long-side contact portion 603C is then lowered from above onto a predetermined position on the work location with the long-side contact portion 603C facing downward, thereby bonding and affixing the long-side rib 603L to the back substrate 11B.
Lowering the long-side rib 603L onto the work location from above the back substrate 11B in this manner is preferred, as it enables the workability associated with bonding and affixing the long-side rib 603L to be improved.

Further, a configuration may also be used in which the rib spacer 604 is engaged within the long-side contact portion 603C so as to extend along the lengthwise direction of the long-side rib 603L in substantially the center of the long-side contact portion 603C, a region in which the rib adhesive 503 is applied is formed along one side of the rib spacer 604, and a section of the rib double-sided tape is provided along the other side of the rib spacer 604. Because leakage of a small amount of the rib adhesive 503 is possible, the region in which the rib adhesive 503 is applied is preferably the region nearer the long-side protective wall 103W.

By adopting this type of configuration, in a similar manner to that described above for the third embodiment, because the rib double-sided tape 502 and the rib adhesive 503 are used in combination, leakage of the rib adhesive 503 can be prevented, positioning of the two elements being bonded is simplified, and the two members need not be secured until the adhesive curing period has elapsed, meaning the bonding process is simplified.

Moreover, a double-sided tape or the like may be used to temporarily secure the rib spacer 604 to a predetermined position on the back substrate 11B of the solar cell module 2. Specifically, during bonding of the long-side rib 603L to which the rib adhesive 503 has been applied to the back substrate 11B, by guiding the long-side rib 603L using the rib spacer 604 that has been secured temporarily to the back substrate 11B and the channel 603G within the long-side rib 603L, and inserting the rib spacer 604 into the channel 603G, the long-side rib 603L can be bonded simply and precisely to the solar cell module 2.
The rib spacer 604 need not be continuous along the entire lengthwise direction of the long-side rib 603L.

According to the structure described above, the rib spacer 604 is used to determine the bonding position of the long-side rib 603L, and also to determine the spacing between the long-side rib 603L and the back substrate 11B of the solar cell module 2, and therefore bonding can be performed with an appropriate thickness for the rib adhesive 503 maintained between the two members being bonded.

### Modified examples of the fourth embodiment

Next is a description of modified examples of the fourth embodiment of the present invention.
The basic structure of the solar cell panels of these modified examples is the same as that of the fourth embodiment, but differs in that a rib spacer is added to the structures of the long-side ribs and protective ribs illustrated in Fig. 22, Fig. 23, Fig. 24 and Fig. 25. In order to facilitate understanding of these modified examples, only the bonding of the solar cell module 2 to the long-side ribs 203L and 303L is described below.

In the long-side contact portion 103C and the long-side contact portion 303C of the long-side rib 203L and the long-side rib 303L respectively, the channel 603G inside which the rib spacer 604 is disposed extends along the lengthwise direction of the long-side rib 203L or the long-side rib 303L. The channel 603G is formed in substantially the center of the long-side contact portion 103C or the long-side contact portion 303C, so that the rib adhesive 503 can be applied in regions along both sides of the channel 603G.

According to the structure described above, the rib spacer 604 is used to determine the bonding position of the long-side rib 203L or the long-side rib 303L, and also to determine the spacing between the long-side rib 203L or the long-side rib 303L and the back substrate 11B of the solar cell module 2, and therefore bonding can be performed with an appropriate thickness for the layer of the rib adhesive 503 maintained between the two members being bonded.

### Fifth embodiment

A fifth embodiment of the present invention is described below with reference to Fig. 35 and Fig. 36.
The basic structure of the solar cell panel of this embodiment is the same as that of the first embodiment, but the structure used for installing the solar cell panel differs from that of the first embodiment. Accordingly, for the present embodiment, only the structure relating to the installation of the solar cell panel is described using Fig. 35 and Fig. 36, whereas descriptions of the other structural elements and the like are omitted.
Fig. 35 is a schematic illustration describing the structure of a long-side rib in a solar cell panel according to the present embodiment. Fig. 36 is a schematic illustration describing a method of installing the solar cell panel of Fig. 35.
Those structural elements that are the same as elements within the first embodiment are labeled using the same reference signs, and their descriptions are omitted.

1 A long-side rib (first protective rib) 703L of a solar cell panel 701 according to the present embodiment comprises the flange 103F, the long-side contact portion 103C, the long-side protective wall 103W, and a rib-side engagement portion (engagement portion) 703J.

The rib-side engagement portion 703J is used, together with a fixture 804, when affixing the solar cell panel 701 to a mounting structure (installation surface) 5 of a mount.
The rib-side engagement portion 703J is a plate-shaped member that extends from an edge of the long-side contact portion 103C positioned outside the long-side protective wall 103W, and extends toward the transparent substrate 11A.

The plate-like member that links the flange 103F and the long-side contact portion 103C may extend from a position on the long-side contact portion 103C beneath the long-side protective wall 103W toward the flange 103F, as illustrated in Fig. 35, or may extend from a position on the long-side contact portion 103C beneath the region that contacts the solar cell module 2 toward the flange 103F, as illustrated in Fig. 36, and there are no particular limitations in this regard.

The fixture 804 is used, together with the rib-side engagement portion 703J, for affixing the solar cell module 2 to the mounting structure 5. The fixture 804 comprises a fixing bolt 804B that is affixed to the mounting structure 5, and a fixture-side engagement portion 804H that engages with the rib-side engagement portion 703J of the long-side rib 703L and presses the long-side rib 103L against the mounting structure 5.
The fixture-side engagement portion 804H is a U-shaped member when viewed in cross-section, and is formed so as to engage with the rib-side engagement portion 703J.

As illustrated in Fig. 36, when affixing the solar cell panels 701 to the mounting structure 5, the solar cell panels 701 are positioned with the long-side ribs 703L of adjacent panels aligned next to each other. Then, the fixture 804 is inserted between the solar cell panels 701 so that the fixture-side engagement portion 804H engages with the rib-side engagement portions 703J. The fixing bolt 804B is then inserted through the fixture-side engagement portion 804H and screwed into the mounting structure 5. This secures the solar cell panels 701 to the mounting structure 5.
In the present embodiment, the fixtures 804 are provided at four locations on each solar cell panel 701, and are positioned at locations on the long-side ribs 703L that are close to extensions of the centerlines of the short-side ribs.

According to the configuration described above, by securing each of the fixtures 804 to the mounting structures 5 with the fixture-side engagement portions 804H engaged with the rib-side engagement portions 703J, the long-side ribs 703L can be affixed to the mounting structures 5, enabling the solar cell panels 701 to be secured to the mounting structures 5.

Moreover, unlike the case where the engagement portion of the long-side rib 3L that engages with the fixture 4 is disposed in the vicinity of the mounting structure 5 as illustrated in Fig. 3, the rib-side engagement portion 703J is provided on the long-side contact portion 103C that is bonded to the back substrate 11B, and therefore the operation of affixing the solar cell panels 701 to the battens 5 is simplified, and the edges of the solar cell modules 2 are less prone to damage.

In other words, when the engagement portion is disposed in the vicinity of the mounting structure 5 as illustrated in Fig. 3, the tool for securing the fixture 4, namely the driver used for turning the fixing bolt 4B, must travel past the side of the solar cell module 2 to a position close to the mounting structure 5, meaning there is a possibility that the tool may make contact with a edge portion of the solar cell module 2, resulting in damage to the edge of the solar cell module 2. In contrast, when the rib-side engagement portion 703J is disposed on the long-side contact portion 103C, the above-mentioned tool need not travel past the side of the solar cell module 2, meaning workability is more favorable. Accordingly, the edges of the solar cell module 2 are less prone to damage during affixing of the solar cell panels 701 to the mounting structures 5.

### Reference Signs List

- 101, 201, 301, 401, 501, 601, 701: Solar cell panel
- 2: Solar cell module
- 11A: Transparent substrate
- 13: Photovoltaic layer
- 11B: Back substrate
- 103L, 203L, 303L, 603L, 703L: Long-side rib (first protective rib)
- 3S: Short-side rib (support rib)
- 104P, 204P, 304P: Protective rib (second protective rib)
- 103C, 303C, 603C: Long-side contact portion (contact portion)
- 103W, 203W: Long-side protective wall (protective wall)
- 104C, 304C: Protective contact portion (contact portion)
- 104W, 204W: Protective wall
- 405: Rib sealing material (sealing material)
- 502: Rib double-sided tape (double-sided tape)
- 503: Rib adhesive (adhesive)
- 604: Rib spacer (spacer)
- 703J: Rib-side engagement portion (engagement portion)
- 804: Fixture
- 5: Mounting structure (installation surface)

## Claims

1. A solar cell panel comprising:
a solar cell module in which a transparent substrate, a photovoltaic layer formed on the transparent substrate, and a back substrate that seals the photovoltaic layer between the transparent substrate and the back substrate are stacked, in that order, with the transparent substrate disposed closest to a surface through which incident light enters,
a pair of first protective ribs, which are fixed to the back substrate, protrude outward from edges of the solar cell module, and are disposed in an opposing manner,
a pair of support ribs, which are fixed to the back substrate, and are disposed across a space between the pair of first protective ribs at positions distant from edges of the back substrate, and
a pair of second protective ribs, which are disposed across a space between the pair of first protective ribs, and protrude outward from edges of the solar cell module.

2. The solar cell panel according to claim 1, wherein
at least one of the first protective ribs and the second protective ribs comprises:
a contact portion, which contacts and is fixed to the back substrate, and protrudes outward from an edge of the solar cell module in a plate-like form, and
a protective wall, which extends toward the solar cell module from a portion of the contact portion disposed beyond an outside edge of the solar cell module.

3. The solar cell panel according to claim 1, wherein
at least one of the first protective ribs and the second protective ribs comprises:
a contact portion, which contacts and is fixed to the back substrate, and protrudes outward from an edge of the solar cell module in a plate-like form, and
a protective wall, which extends away from the solar cell module from a portion of the contact portion disposed beyond an outside edge of the solar cell module.

4. The solar cell panel according to claim 2 or 3, wherein a sealing material is disposed between an edge of the solar cell module and at least one of the protective wall and the contact portion.

5. The solar cell panel according to claim 1, wherein
at least one of the first protective ribs and the second protective ribs comprises a contact portion that contacts and is fixed to the back substrate, and
the contact portion protrudes outward from an edge of the solar cell module in a plate-like form.

6. The solar cell panel according to claim 5, wherein a sealing material is disposed between an edge of the solar cell module and the contact portion.

7. The solar cell panel according to any one of claims 1 to 6, wherein
edge regions of a contact surface between the back substrate and the contact portion of at least one of the support ribs, the first protective ribs and the second protective ribs are affixed with a double-sided tape having a pressure-sensitive adhesive coated on both surfaces, and
a region of the contact surface sandwiched between sections of the double-sided tape is affixed with an adhesive.

8. The solar cell panel according to any one of claims 1 to 6, wherein
a contact surface between the back substrate and the contact portion of at least one of the support ribs, the first protective ribs and the second protective ribs is provided with:
a spacer that determines a spacing between the back substrate and at least one of the support ribs, the first protective ribs and the second protective ribs, and
an adhesive that affixes the back substrate to at least one of the support ribs, the first protective ribs and the second protective ribs.

9. The solar cell panel according to any one of claims 1 to 8, wherein
a fixture is provided for affixing the first protective ribs to an installation surface for the solar cell module, and
the first protective ribs comprise:
a contact portion, which contacts and is fixed to the back substrate, and protrudes outward from an edge of the solar cell module in a plate-like form, and
an engagement portion, which is disposed on a portion of the contact portion beyond an outside edge of the solar cell module, extends toward the solar cell module, and engages with the fixture.
